# EUROPEAN PATENT APPLICATION

(11) **EP 1 640 803 A2**
(43) Date of publication of application: **29.03.2006**
(21) Application number: 05020808.1
(22) Date of filing: 23.09.2005
(51) Int. Cl.: G03F 7/09, G03F 7/038, G03F 7/032, G03F 7/035

(54) **Photosensitive lithographic printing plate**

(30) Priority: 24.09.2004 JP 2004278360
(71) Applicant: FUJI PHOTO FILM CO., LTD., Minami-Ashigara-shi, Kanagawa (JP)
(72) Inventor: Arimura, Keisuke, Yoshida-cho, Haibara-gun, Shizuoka (JP); Goto, Takahiro, Yoshida-cho, Haibara-gun, Shizuoka (JP)
(74) Representative: HOFFMANN EITLE

(57) **Abstract**

A photosensitive lithographic printing plate comprising: a hydrophilic support; a photosensitive layer; and a protective layer, wherein the photosensitive layer contains a compound having an ethylenically unsaturated double bond, a high molecular binder having a crosslinking group and a hexaaryl biimidazole compound; and the protective layer has an oxygen permeability at 25 °C under one atmosphere of from 1.0 to 20 cc/m²·day.

## Description

### FIELD OF THE INVENTION

The present invention relates to a photopolymerizable composition and a photosensitive lithographic printing plate. In particular, the invention relates to a photosensitive lithographic printing plate having excellent storage stability and high printing resistance.

### BACKGROUND OF THE INVENTION

In a negative working photosensitive lithographic printing plate, in general, the image formation is carried out in a process for coating a photosensitive composition on a support such as a roughed aluminum plate, exposing a desired image, polymerizing or crosslinking an image area (light irradiated area) to make it insoluble in a developing solution, and eluting out a non-image area with the developing solution. As the photosensitive composition to be used for such a purpose, photopolymerizable compositions have hitherto been well known, and a part thereof has been provided for practical use. Furthermore, recent photopolymers with high sensitivity employing a technology of the photoinitiation system which is highly sensitive to visible light are advanced to an extent of high sensitization to a region where they are used for direct plate making with a visible laser and become widespread as a so-called CTP plate. As recording materials compatible with ultraviolet rays or visible light laser, there are a number of radical polymerization type negative working recording materials as described in U.S. Patent No. 2,850,445 and JP-B-44-20189, and the like.

However, in general, the radical polymerization system causes a large reduction of the sensitivity by polymerization hindrance of oxygen in air. For the purpose of preventing it, an oxygen-blocking protective layer is provided. However, there are fears that the storage stability is deteriorated because of prevention of the oxygen hindrance of oxygen and that fogging is caused due to dark polymerization. Usually, for the purpose of preventing it, it is the present situation that it is designed to add a polymerization inhibitor, thereby making both sensitivity and storage stability compatible with each other.

### SUMMARY OF THE INVENTION

An object of the invention is to provide a photosensitive lithographic printing plate having good storage stability and excellent printing resistance in a radical polymerization system photographic material with high sensitivity.

As a result of extensive and intensive investigations, the present inventor improved the storage stability by providing a protective layer with appropriate oxygen permeability to trap an extremely small amount of a radical with oxygen. However, when a protective layer with low oxygen-blocking properties is used, a reduction of the printing resistance is brought. Thus, it has been found that by using a specific photosensitive layer as prepared by containing a crosslinking group in the side chain of a binder or other means, a lithographic printing plate having high sensitivity and excellent storage stability, an aspect of which has not been conventionally seen, is obtained, leading to accomplishment of the invention.

Specifically, the foregoing problem has been achieved by a photosensitive lithographic printing plate comprising a hydrophilic support having thereon a photosensitive layer and a protective layer, wherein the photosensitive layer contains an ethylenically unsaturated double bond-containing compound (compound having an ethylenically unsaturated double bond), a crosslinking group-containing high molecular binder (high molecular binder having a crosslinking group), and a hexaaryl biimidazole compound; and the protective layer has an oxygen permeability (at 25 °C under one atmosphere) in the range of from 1.0 to 20 cc/m²·day.

### DETAIL DESCRIPTION OF THE INVENTION

The invention will be hereunder described in detail.

First of all, a photopolymerizable composition for forming a photosensitive layer containing an ethylenically unsaturated double bond-containing compound, a crosslinking group-containing high molecular binder, and a hexaaryl biimidazole compound, which the photosensitive lithographic printing plate of the invention has, will be described.

### <Photopolymerizable composition>

The photopolymerizable composition for forming a photosensitive layer which the photosensitive lithographic printing plate of the invention has contains, as essential components, an ethylenically unsaturated double bond-containing compound (hereinafter abbreviated as "ethylenically unsaturated bond-containing compound"), a crosslinking group-containing high molecular binder as an alkaline water-soluble or swelling binder, and a hexaaryl biimidazole compound as a photopolymerization initiator and further contains a variety of compounds such as a coloring agent, a plasticizer, and a thermal polymerization inhibitor, if desired.

### [Ethylenically unsaturated bond-containing compound (a)]

The ethylenically unsaturated bond-containing compound as referred to herein is a compound containing at least one ethylenically unsaturated bond and when the photopolymerizable composition is irradiated with active rays, causes addition polymerization by the action of a photopolymerization initiator, thereby contributing to crosslinking and curing.

The ethylenically unsaturated double bond-containing compound can be arbitrarily chosen among, for example, compounds containing at least one, preferably two or more, and more preferably from 2 to 6 terminal ethylenically unsaturated bonds. The ethylenically unsaturated double bond-containing compound has a chemical morphology such as monomers and prepolymers, namely dimers, trimers and oligomers, or mixtures thereof, and copolymers thereof.

Examples of monomers and copolymers thereof include esters of an unsaturated carboxylic acid (for example, acrylic acid, methacrylic acid, itaconic acid, crotonic acid, isocrotonic acid, and maleic acid) and an aliphatic polyhydric alcohol compound and amides of an unsaturated carboxylic acid and an aliphatic polyhydric amine compound. With respect to specific examples of the monomer of the ester between an aliphatic polyhydric alcohol compound and an unsaturated carboxylic acid, examples of acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimediacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)pheny]dimetliylmethane, and bis[p-(methacryloxyethaxy)phenyl]dimethylmethane.

Examples of itaconic esters include ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate. Examples of crotonic esters include ethylene glycol dicrotonate, tetramethylene glycol dicrotonate, pentaerythritol dicrotonate, and sorbitol tetradicrotonate. Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate. In addition, mixtures of the foregoing ester monomers can be enumerated. Furthermore, specific examples of the monomer of the amide between an aliphatic polyhydric amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamdie, and xylylene bismethacrylamide.

Other examples include vinyl urethane compounds containing two or more polymerizable vinyl groups in one molecule thereof resulting from adding a hydroxyl group-containing vinyl monomer represented by the following formula (A) to a polyisocyanate compound containing two or more isocyanate groups in one molecule thereof as described in JP-B-48-41708.

CH₂C(R)COOCH₂CH(R')OH (A)

In the foregoing formula (A), R and R' each represents H or CH₃.

Furthermore, urethane acrylates as described in JP-A-51-37193 and JP-B-2-32293; polyester acrylates as described in JP-A-48-64183, JP-B-49-43191, and JP-B-52-30490; and polyfunctional acrylates or methacrylates such as epoxy acrylates obtained by reaction between an epoxy resin and (meth)acrylic acid can be enumerated. Photocurable monomers and oligomers as introduced in *Journal of the Adhesion Society of Japan,* Vol. 20, No. 7, pages 300 to 308 (1984) can also be used. Incidentally, the amount of such an ethylenically unsaturated bond-containing compound to be used is usually in the range of from 5 to 80 % by weight, and preferably from 30 to 70 % by weight based on the total weight of the photosensitive layer.

### [Crosslinking group-containing high molecular binder]

In the photosensitive layer of the invention, a high molecular binder containing a crosslinking group in the side chain thereof is used.

The crosslinking group as referred to herein means a group for crosslinking a high molecular binder in the process of radical polymerization reaction which is caused in the photosensitive layer during exposing the photosensitive lithographic printing plate. The crosslinking group is not particularly limited so far as it has such a function. Examples of a functional group which can be subjected to addition polymerization reaction include an ethylenically unsaturated bond group, an amino group, and an epoxy group. Furthermore, the crosslinking group may be a functional group which can become a radical upon irradiation with light. Examples of such a crosslinking group include a thiol group, a halogen group, and an onium salt structure. Above all, an ethylenically unsaturated bond group is preferable, and functional groups represented by the following formulae (1) to (3) are especially preferable.

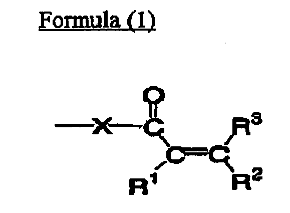

In the foregoing formula (1), R¹ to R³ each independently represents a monovalent organic group. Preferred examples of R¹ include a hydrogen atom and an optionally substituted alkyl group; and above all, a hydrogen atom and a methyl group are preferable because of high radical reactivity. Examples of each of R² and R³ include a hydrogen atom, a halogen atom, an amino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable because of high radical reactivity.

X represents an oxygen atom, a sulfur atom, or N(R¹²)-; and R¹² represents a hydrogen atom or a monovalent organic group. Here, examples of R¹² include an optionally substituted alkyl group; and above all, a hydrogen atom, a methyl group, an ethyl group, and an isopropyl group are preferable because of high radical reactivity.

Here, examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amide group, an alkylsulfonyl group, and an arylsulfonyl group.

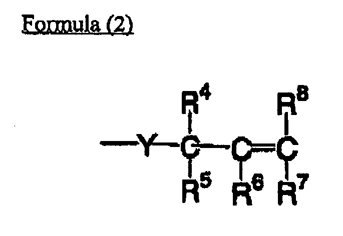

In the foregoing formula (2), R⁴ to R⁸ each independently represents a monovalent organic group. Preferred examples of each of R⁴ to R⁸ include a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, and an optionally substituted arylsulfonyl group; and above all, a hydrogen atom, a carboxyl group, an alkoxycarbonyl group, an optionally substituted alkyl group, and an optionally substituted aryl group are preferable.

As the substituent which can be introduced, those which are the same as in the formula (1) are enumerated. Furthermore, Y represents an oxygen atom, a sulfur atom, or -N(R¹²)-. R¹² is synonymous with R¹² in the formula (1), and preferred examples thereof are also the same.

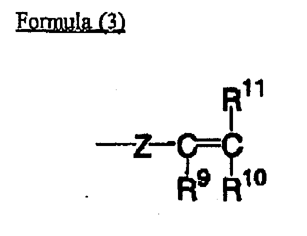

In the foregoing formula (3), examples of R⁹ preferably include a hydrogen atom or an optionally substituted alkyl group. Above all, a hydrogen atom and a methyl group are preferable because of high radical reactivity. R¹⁰ and R¹¹ each independently represents a hydrogen atom, a halogen atom, an amino group, a dialkylamino group, a carboxyl group, an alkoxycarbonyl group, a sulfo group, a nitro group, a cyano group, an optionally substituted alkyl group, an optionally substituted aryl group, an optionally substituted alkoxy group, an optionally substituted aryloxy group, an optionally substituted alkylamino group, an optionally substituted arylamino group, an optionally substituted alkylsulfonyl group, or an optionally substituted arylsulfonyl group. Above all, a hydrogen atom, a carboxyl group, an alkoxycarbonyl group, an optionally substituted alkyl group, and an optionally substituted aryl group are preferable because of high radical reactivity.

As the substituent which can be introduced, those which are the same as in the formula (1) are enumerated. Furthermore, Z represents an oxygen atom, a sulfur atom, -N(R¹³)-, or an optionally substituted phenylene group. Examples of R¹³ include an optionally substituted alkyl group. Above all, a methyl goup, an ethyl group, and an isopropyl group are preferable because of high radical reactivity.

Since the foregoing high molecular binder containing a crosslinking group in the side chain thereof according to the invention is required such that not only it functions as a film forming agent of the photosensitive layer, but also it is soluble in a developing solution, preferably an alkaline developing solution, it is preferably an alkaline water-soluble or swelling organic high molecular polymer. For that reason, it is preferable that the high molecular binder of the invention contains, in addition to a crosslinking group, an alkali-soluble group, for example, a carboxyl group in the side chain thereof.

In the case where the high molecular binder containing a crosslinking group in the side chain thereof is a water-soluble organic high molecular polymer, water development becomes possible.

Examples of the foregoing high molecular binder according to the invention include those as described in JP-A-59-53836 and JP-A-59-71048, namely (meth)acrylic acid copolymers, itaconic acid copolymers, crotonic acid copolymers, maleic acid copolymers, and partially esterified maleic acid copolymers, each containing a crosslinking group (for example, an allyl group and a (meth)acryloyl group) in the side chain thereof.

As the high molecular binder according to the invention, polyurethanes, acidic cellulose derivatives, adducts resulting from addition of a cyclic acid anhydride to a hydroxyl group-containing addition polymer, and the like are also useful.

Above all, (meth)acrylic acid copolymers and polyurethanes are more preferable. Polyurethane resins are especially preferable because nevertheless an acid value of the photosensitive layer is low, they can inhibit development damage in an exposed area without reducing developability in an unexposed area and have both good staining properties and high printing resistance.

The polyurethane resin containing a crosslinking group in the side chain thereof will be hereunder described in more detail.

The polyurethane resin containing a crosslinking group in the side chain thereof which is especially preferably used in the invention can be obtained by polyaddition reaction of (i) a diisocyanate compound, (ii) a carboxyl group-containing diol compound and (iii) a crosslinking group-containing diisocyanate compound, and optionally, (iv) a carboxyl group-free diol compound.

The diisocyanate compound and the diol compound which are the raw materials of the foregoing polyurethane resin will be hereunder described.

### (i) Diisocyanate compound:

Examples of the diisocyanate compound include a diisocyanate compound represented by the formula (4).

OCN-L-NCO (4)

In the foregoing formula (4), L represents an optionally substituted divalent aliphatic or aromatic hydrocarbon group. If desired, L may contain other functional group which does not react with the isocyanate group, for example, a carbonyl group, an ester group, a urethane group, an amide group, and an ureido group. More specifically, L represents a single bond or an optionally substituted divalent aliphatic or aromatic hydrocarbon group (preferred examples of the substituent include an alkyl group, an aralkyl group, an aryl group, an alkoxy group, and a halogeno group). Above all, an alkylene group having from 1 to 20 carbon atoms and an arylene group having from 6 to 15 carbon atoms are preferable; and an alkylene group having from 1 to 8 carbon atoms is more preferable. Furthermore, if desired, L may contain other functional group which does not react with the isocyanate group, such as a carbonyl group, an ester group, a urethane group, an amide group, an ureido group, and an ether group.

Specific examples thereof include aromatic diisocyanate compounds (for example, 2,4-tolylene diisocyanate, a dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyl-4,4'-diisocyanate); aliphatic diisocyanate compounds (for example, hexamethylene diisocyanate, trimethylhexamethylene diisocyanate, lysine diisocyanate, and dimeric acid diisocyanate); alicyclic diisocyanate compounds (for example, isophorone diisocyanate, 4,4'-methylenebis(cyclohexyl isocyanate), methylcyclohexane-2,4-(or 2,6-)diisocyanate, and 1,3-(isocyanatomethyl)-cyclohexane; and diisocyanate compound which is a reaction product between a diol and a diisocyanate (for example, an adduct of one mole of 1,3-butylene glycol and 2 moles of tolylene diisocyanate).

The diisocyanate compound may be used singly or in combination of two or more kinds thereof. In view of a balance between printing resistance and staining properties, it is preferred to use a combination of two or more kinds thereof It is especially preferred to use at least one kind of each of an aromatic diisocyanate compound (wherein L represents an aromatic group) and an aliphatic diisocyanate compound (wherein L represents an aliphatic group).

The amount of the diisocyanate to be used is preferably from 0.8 to 1.2, and more preferably from 0.9 to 1.1 in terms of a molar ratio to the diol compound. In the case where an excess of the diisocyanate compound is used against the diol compound so that the isocyanate group remains in the polymer terminals, it is preferable that after completion of urethanization reaction, the reaction product is treated with an alcohol or an amine so that the polyurethane resin is finally synthesized in the form that no isocyanate group remains. (ii) Diol compound containing at least one carboxyl group:
Examples of the diol compound containing at least one carboxyl group include diol compounds represented by the formulae (5), (6) and (7) and/or compounds resulting from ring opening of a tetracarboxylic dianhydride with a diol compound. The diol compound which is used for ring opening of a tetracarboxylic dianhydride can be used.

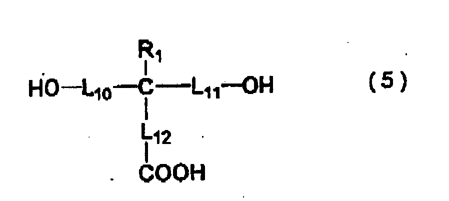

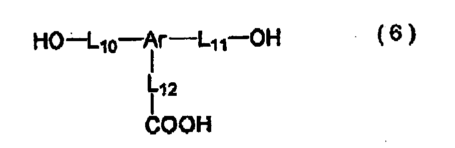

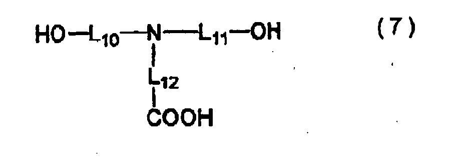

In the foregoing formulae, R_{I} represents a hydrogen atom or an optionally substituted alkyl group, aralkyl group, aryl group, alkoxy group or aryloxy group (examples of the substituent include a cyano group, a nitro group, a halogen atom (for example, -F, -Cl, -Br, and -I), a -CONH₂ group, a -COOR₁₁₃ group, an -OR₁₁₃ group, an -NHCOOR₁₁₃ group, an NHCOR₁₁₃ group, an -NHCONHR₁₁₃ group, and an -OCONHR₁₁₃ (wherein R₁₁₃ represents an alkyl group having from 1 to 10 carbon atoms or an aralkyl group having from 7 to 15 carbon atoms); and preferably a hydrogen atom, an alkyl group having from 1 to 8 carbon atoms, or an aryl group having from 6 to 15 carbon atoms. L₁₀, L₁₁, and L₁₂ may be the same or different and each represents a single bond or an optionally substituted divalent aliphatic or aromatic hydrocarbon group (examples of the substituent include an alkyl group, an aralkyl group, an aryl group, an alkoxy group, and a halogeno group); preferably an alkylene group having from 1 to 20 carbon atoms or an arylene group having from 6 to 15 carbon atoms; and more preferably an alkylene group having from 1 to 8 carbon atoms. If desired, L₁₀, L₁₁, and L₁₂ may each contain a functional group which does not react with the isocyanate group (example of the functional group include a carbonyl group, an ester group, a urethane group, an amide group, an ureido group, and an ether group). Incidentally, two or three of R₁, L₁₀, L₁₁, and L₁₂ may be taken together to form a ring. Ar represents an optionally substituted trivalent aromatic hydrocarbon group, and preferably an aromatic group having from 6 to 15 carbon atoms.

Specific examples of the carboxyl group-containing diol compound represented by the formula (5), (6) or (7) include the following compounds.

Namely, examples include 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 2,2-bis(hydroxymethyl)butyric acid, 4,4-bis-(4-hydroxyphenyl)pentanoic acid, tartaric acid, N,N-dihydroxyethylglycine, and N,N-bis(2-hydroxyethyl)-3-carboxypropionamide.

Preferred examples of the tetracarboxylic dianhydride which is used for the formation of at least one kind of a diol compound containing at least one carboxyl group include compounds represented by the formulae (8), (9) and (10).

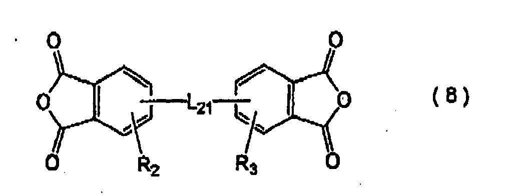

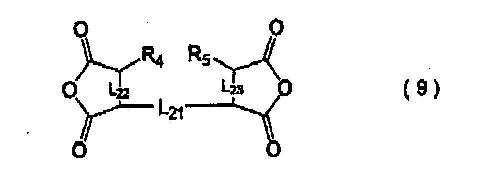

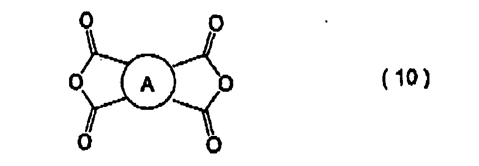

In the foregoing formulae, L₂₁ represents a single bond, an optionally substituted divalent aliphatic or aromatic hydrocarbon group (examples of the substituent include an alkyl group, an aralkyl group, an aryl group, an alkoxy group, a halogeno group, an ester group, and an amide group), -CO-, -SO-, -SO₂-, -O-, or -O-, and preferably a single bond, a divalent aliphatic hydrocarbon group having from 1 to 15 carbon atoms, -CO-, -SO₂-, -O-, or -S-. R₂ and R₃ may be the same or different and each represents a hydrogen atom, an alkyl group, an aralkyl group, an aryl group, an alkoxy group, or a halogeno group; and preferably a hydrogen atom, an alkyl group having from 1 to 8 carbon atoms, an aryl group having from 6 to 15 carbon atoms, an alkoxy group having from 1 to 8 carbon atoms, or a halogeno group. Furthermore, two of L₂₁, R₂, and R₃ may be taken together to form a ring. R₄ and R₅ may be the same or different and each represents a hydrogen atom, an alkyl group, an aralkyl group, an aryl group, or a halogeno group; and preferably a hydrogen atom, an alkyl group having from 1 to 8 carbon atoms, or an aryl group having from 6 to 15 carbon atoms. Moreover, two of L₂₁, R₄, and R₅ may be taken together to form a ring. L₂₂ and L₂₃ may be the same or different and each represents a single bond, a double bond, or a divalent aliphatic hydrocarbon group; and preferably a single bond, a double bond, or a methylene group. A represents a mononucleic or polynucleic aromatic ring, and preferably an aromatic ring having from 6 to 18 carbon atoms.

Specific examples of the compound represented by the formula (8), (9) or (10) include the following compounds.

Namely, examples include aromatic tetracarboxylic anhydrides such as pyromellitic dianhydride, 3,3',4,4'-benzophenonetetracarboxylic dianhydride, 3,3',4,4'-diphenyltetracarboxylic dianhydride, 2,3,6,7-naphthalenetetracarboxylic dianhydride, 1,4,5,8-naphthalenetetracarboxylic dianhydride, 4,4'-sulfonyldiphthalic dianhydride, 2,2-bis(3,4-dicarboxyphenyl)propane dianhydride, bis(3,4-dicarboxyphenyl) ether dianhydride, 4,4'-[3,3'-(alkylphosphoryldiphenylene)-bis(iminocarbonyl)]diphthalic dianhydride, an adduct of hydroquinone diacetate and trimellitic anhydride, and an adduct of diacetyldiamine and trimellitic anhydride; alicyclic tetracarboxylic dianhydrides such as 5-(2,5-dioxotetrahydrofuryl)-3-methyl-3-cyclohexene-1,2-dicarboxylic anhydride (EPICLON B-4400, manufactured by Dainippon Ink and Chemicals, Incorporated), 1,2,3,4-cyclopentanetetracarboxylic dianhydride, 1,2,4,5-cyclohexanetetracarboxylic dianhydride, and tetrahydrofurantetracarboxylic dianhydride; and aliphatic tetracarboxylic dianhydrides such as 1,2,3,4-butanetetracarboxylic dianhydride and 1,2,4,5-pentanetetracarboxylic dianhydride.

By ring opening of such a tetracarboxylic dianhydride with a diol compound, it is possible to synthesize (ii) at least one kind of a diol compound containing at least one carboxyl group. However, it is also possible to synthesize the polyurethane resin of the invention by performing reaction between the diol compound and the diisocyanate compound (ii) and allowing this reaction product to react with the foregoing tetracarboxylic dianhydride, and this method is included in the viewpoint of the invention. Namely, examples of a method for introducing a structural unit derived from the tetracarboxylic dianhydride and the diol compound into the polyurethane resin include the following methods.
a) Method for allowing an alcohol-terminated compound as obtained by ring opening of a tetracarboxylic dianhydride with a diol compound to react with a diisocyanate compound.
b) Method for allowing an alcohol-terminated urethane compound as obtained by reaction of a diisocyanate compound with an excess of a diol compound to react with a tetracarboxylic dianhydride.

With respect to the at least one kind of a diol compound containing at least one carboxyl group, the compound represented by the formula (5) is more preferable because it has high solubility in solvent and its synthesis is easy. Furthermore, the at least one kind of a diol compound containing at least one carboxyl group is introduced into the polyurethane resin binder in such an amount that the polyurethane resin binder contains a carboxyl group in an amount ranging from 0.2 to 4.0 meq/g, preferably from 0.3 to 3.0 meq/g, more preferably from 0.4 to 2.0 meq/g, especially preferably from 0.5 to 1.5 meq/g, and most preferably from 0.6 to 1.2 meq/g. Accordingly, while the content of the structure derived from the at least one kind of a diol compound containing at least one carboxyl group in the polyurethane resin binder is properly chosen depending upon the number of carboxyl groups, what should be used as other diol components, the acid value and molecular weight of the resulting polyurethane resin binder, the composition and pH of the developing solution, and the like, it is, for example, from 5 to 45 % by mole, preferably from 10 to 40 % by mole, and more preferably from 15 to 35 % by mole.

### (iii) Crosslinking group-containing diisocyanate compound:

Examples of the crosslinking group-containing diisocyanate compound include a product as obtained by addition reaction of a triisocyanate compound and one equivalent of a crosslinking group-containing monofunctional alcohol or monofunctional amine compound.

Examples of the triisocyanate compound will be given below, but it should not be construed that the invention is limited thereto.

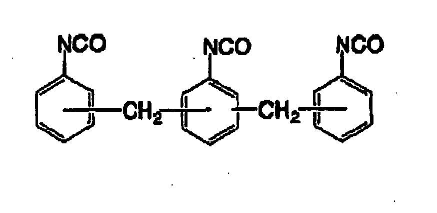

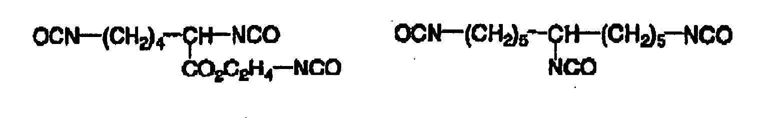

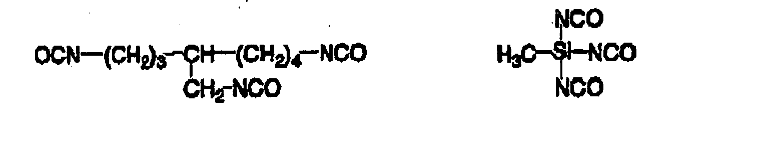

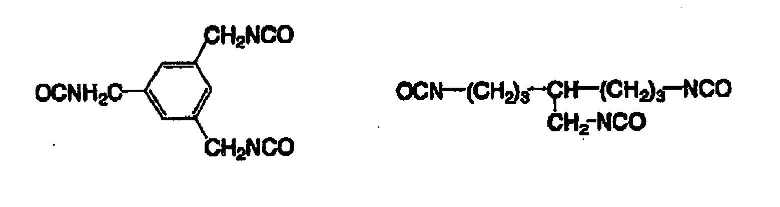

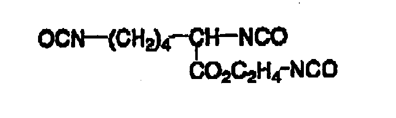

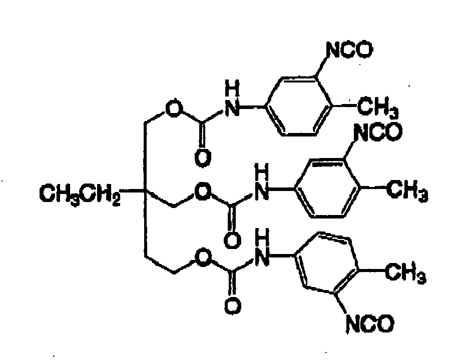

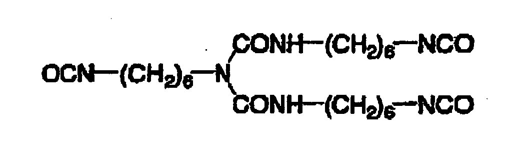

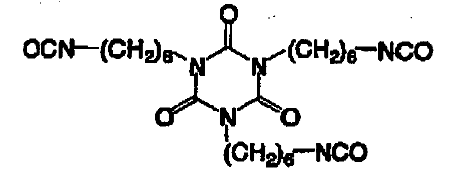

Examples of the crosslinking group-containing monofunctional alcohol or monofunctianal amine compound will be given below, but it should not be construed that the invention is limited thereto. 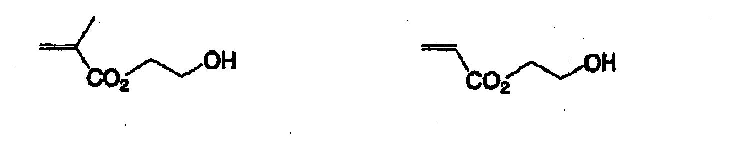 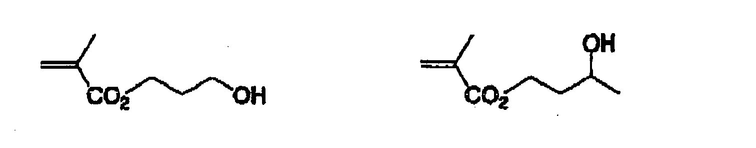 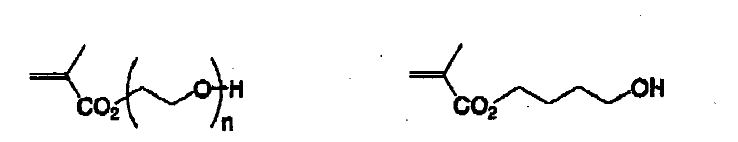 n: an integer of from 2 to 10 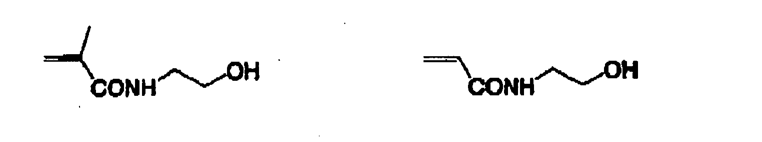 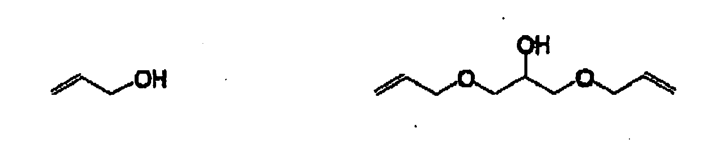 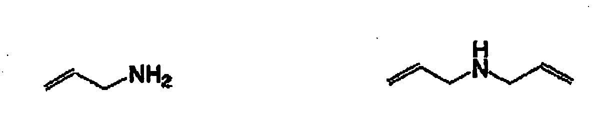 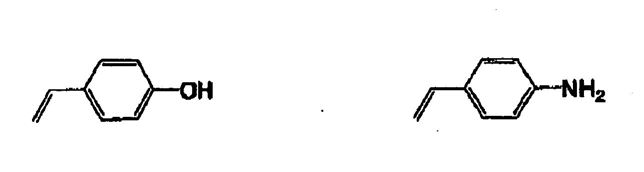 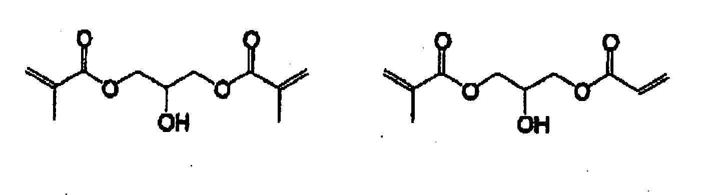 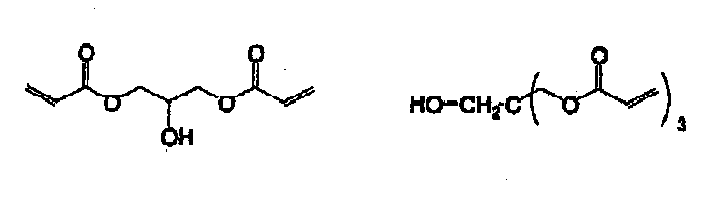 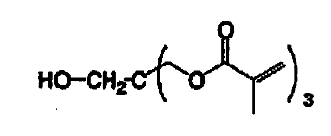 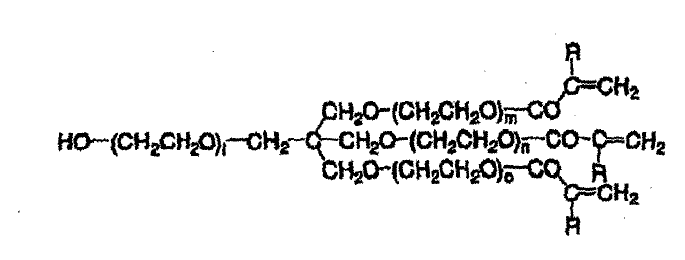 R: hydrogen or a methyl group
l, m, n and o: an integer of from 1 to 20 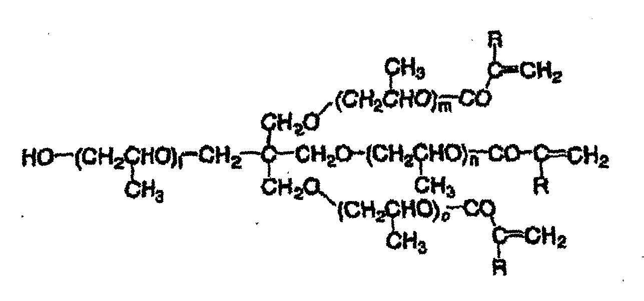 R: hydrogen or a methyl group
l, m, n and o: an integer of from 1 to 20 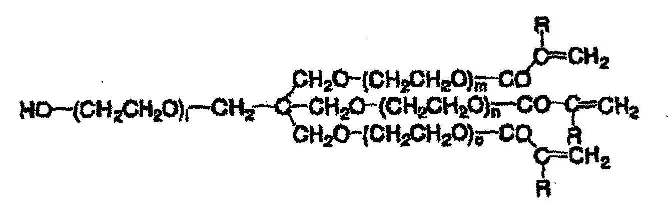 R: hydrogen or a methyl group
l, m, n and o: an integer of from 1 to 20 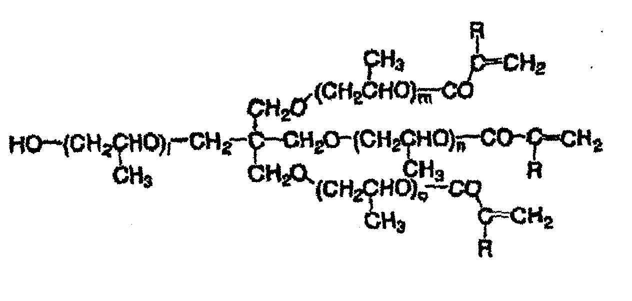 R: hydrogen or a methyl group
l, m, n and o: an integer of from 1 to 20 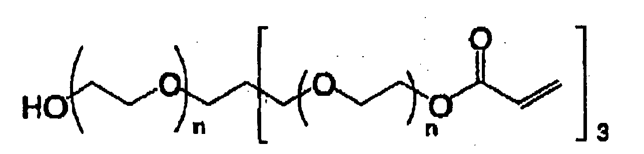 n: an integer of from 2 to 10 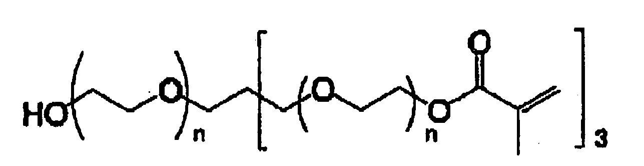 n: an integer of from 2 to 10 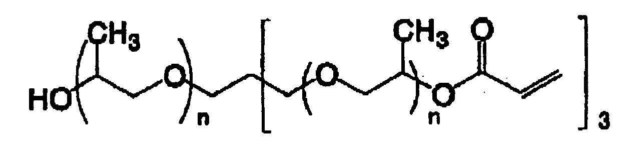 n: an integer of from 2 to 10 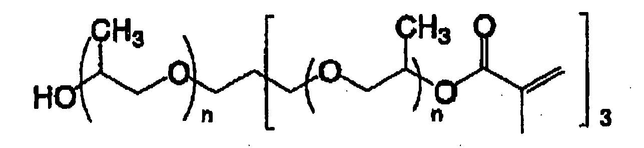 n: an integer of from 2 to 10

Here, as a method for introducing a crosslinking group into the side chain of the polyurethane resin, a method for using a diisocyanate compound containing a crosslinking group in the side chain thereof as the raw material for producing a polyurethane resin is suitable. Examples of a diisocyanate compound containing a crosslinking group in the side chain thereof, which can be obtained by addition reaction of a triisocyanate compound and one equivalent of a crosslinking group-containing monofunctional alcohol or monofunctional amine compound will be given below, but it should not be construed that the invention is limited thereto.

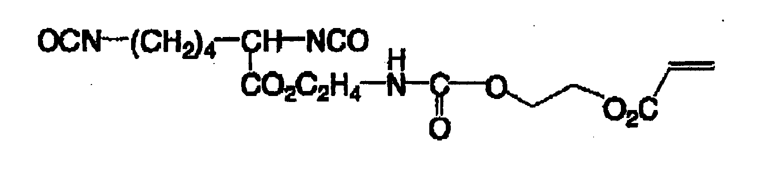

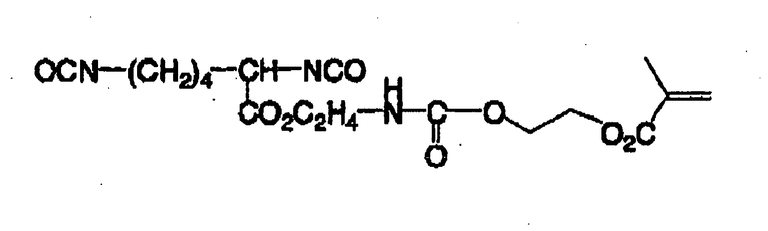

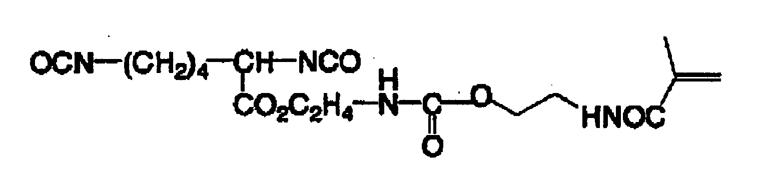

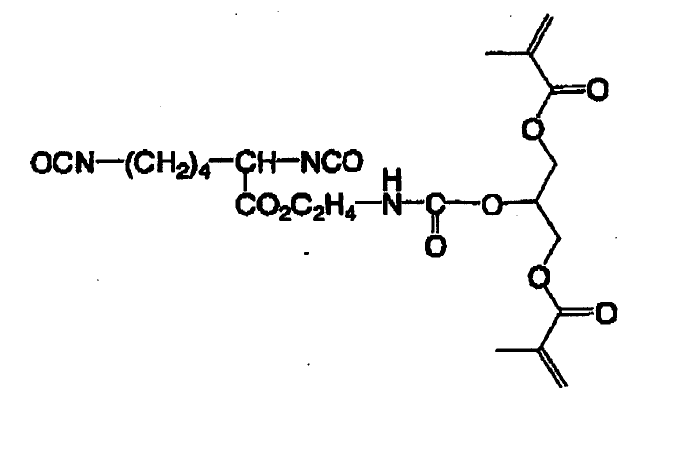

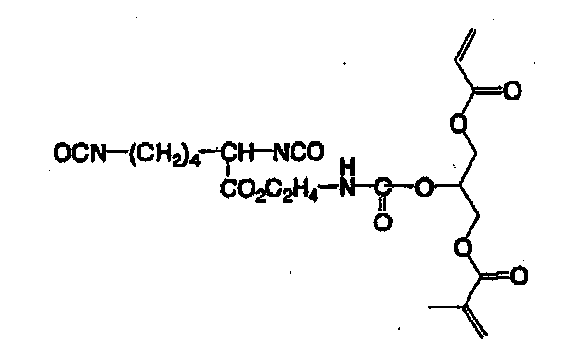

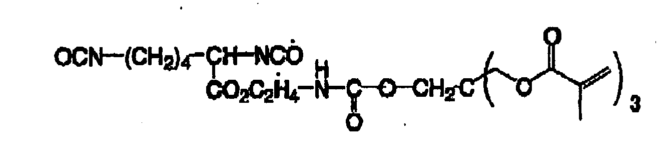

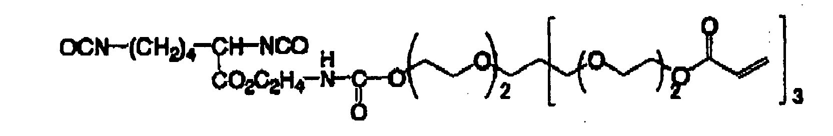

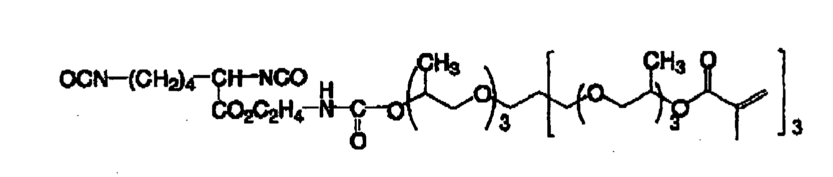

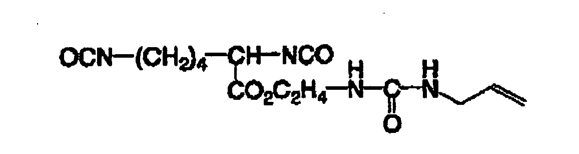

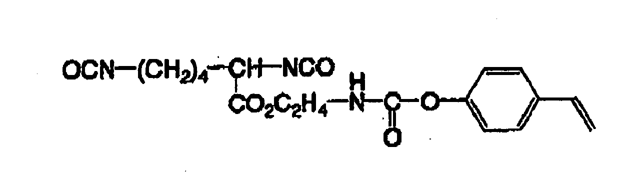

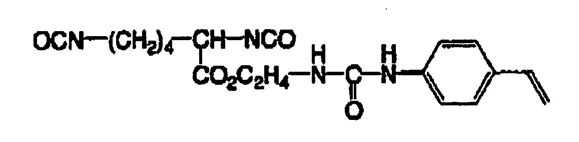

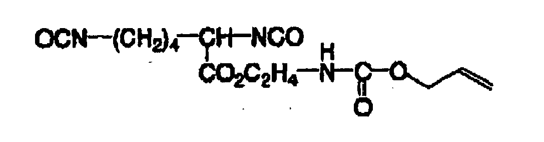

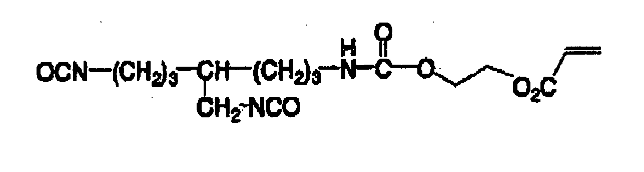

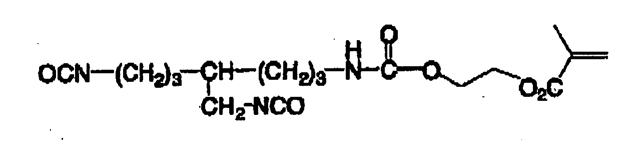

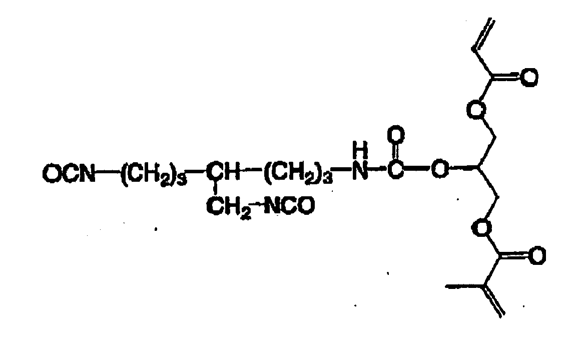

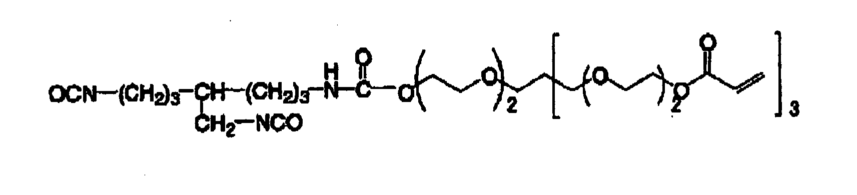

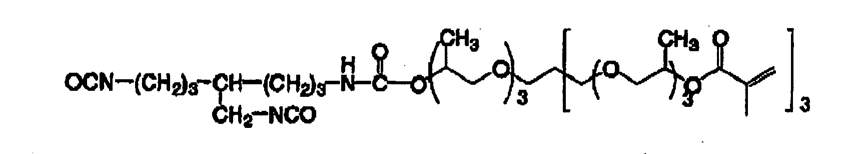

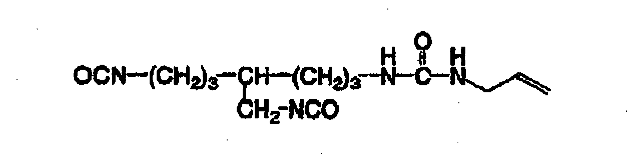

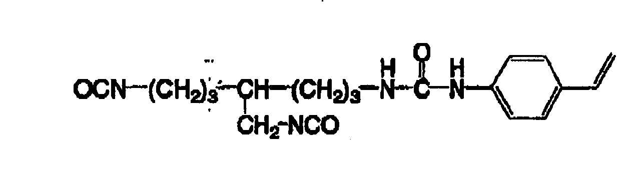

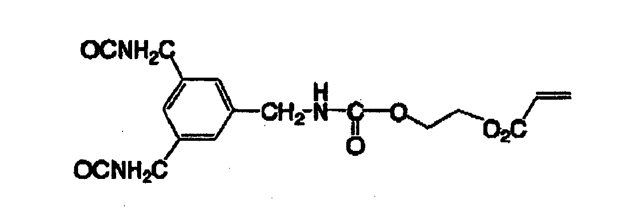

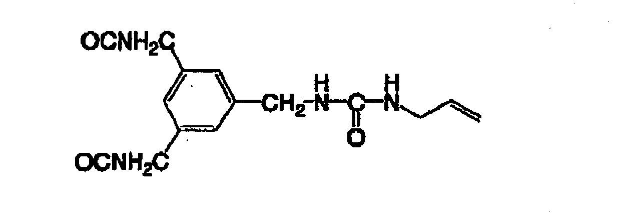

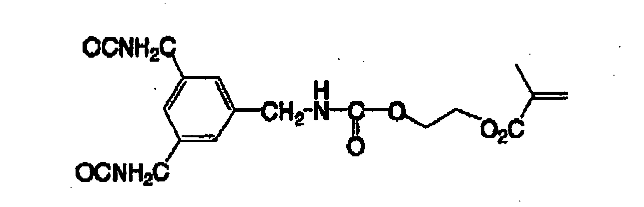

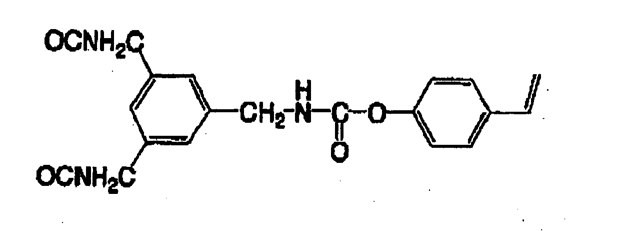

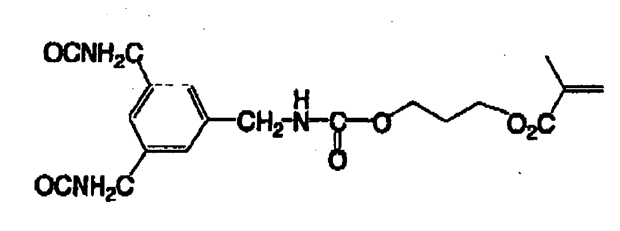

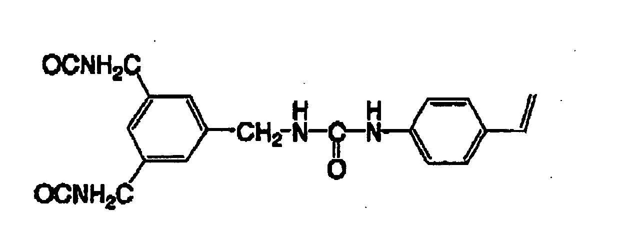

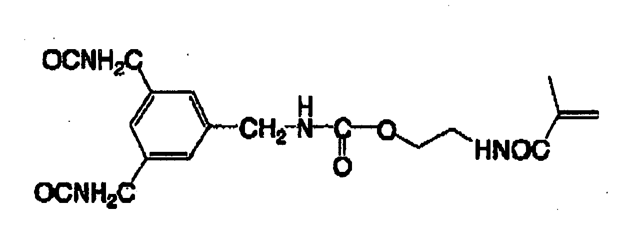

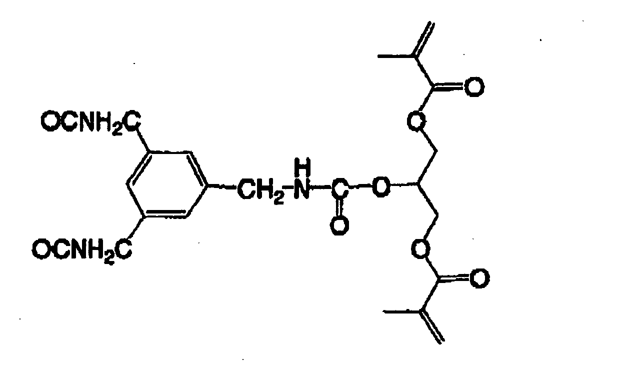

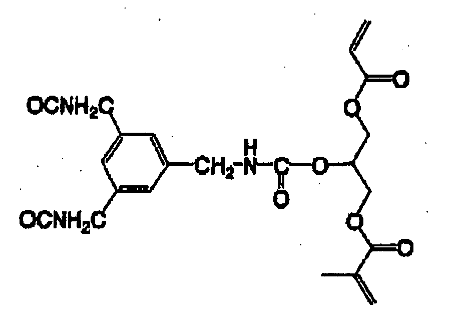

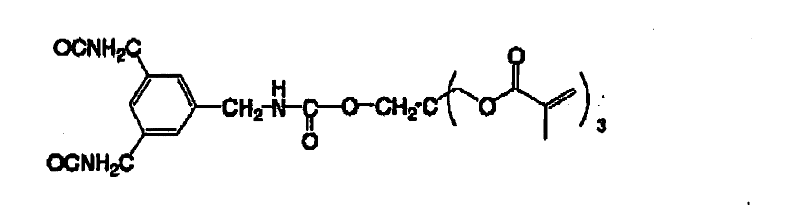

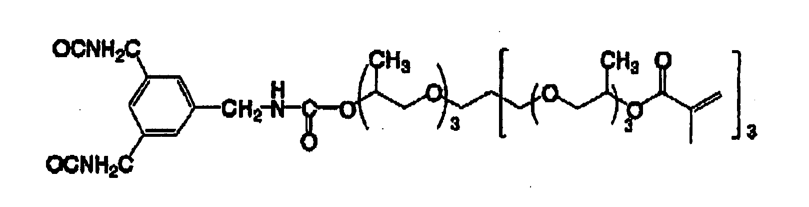

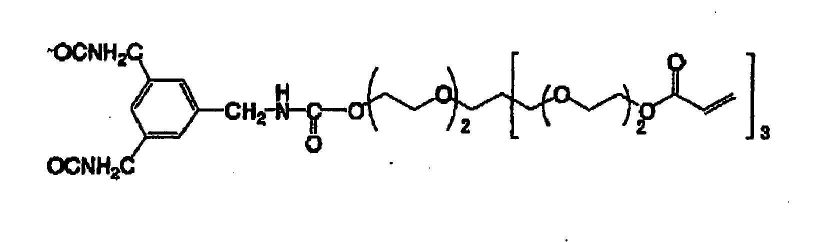

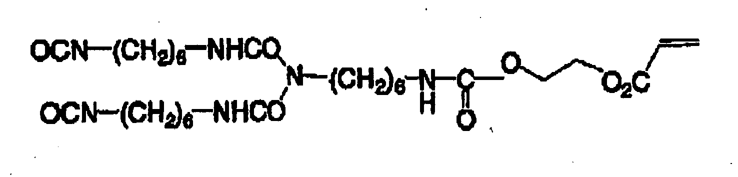

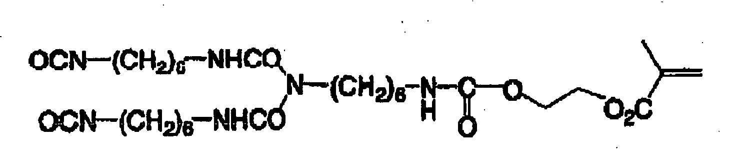

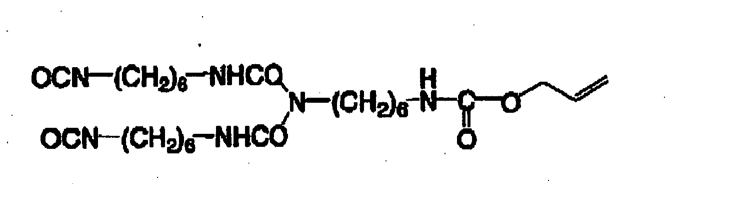

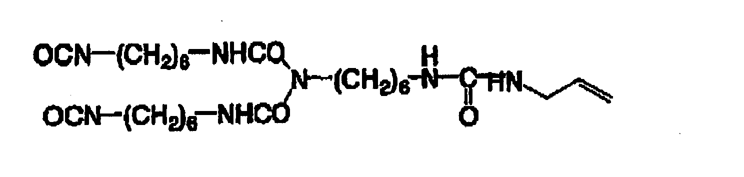

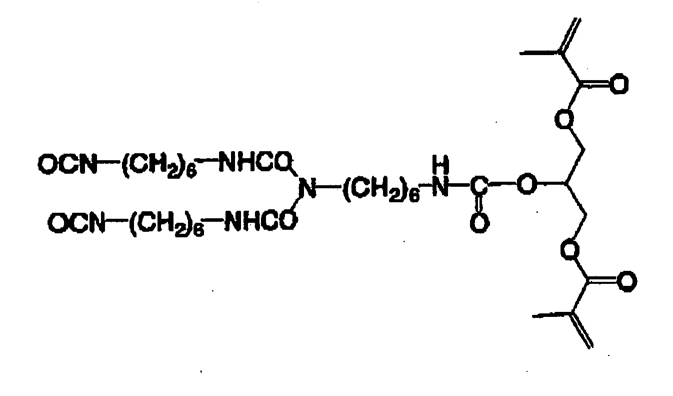

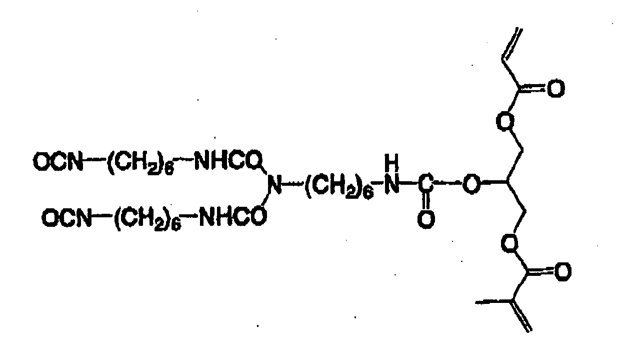

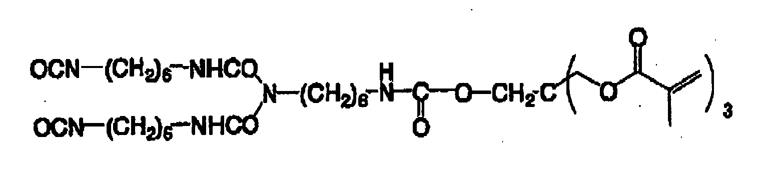

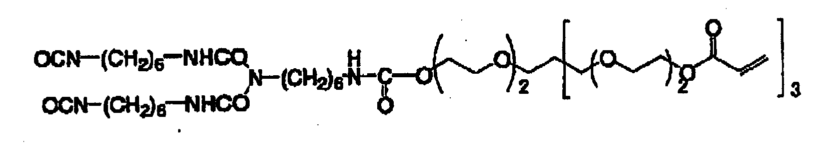

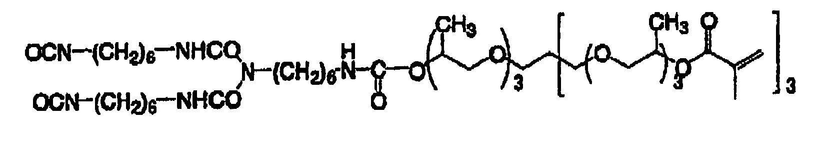

### (iv) Other diol compound:

As a method for introducing an unsaturated group into the side chain of the polyurethane resin, in addition to the foregoing methods, a method for using a diol compound containing an unsaturated group in the side chain thereof as the raw material for producing a polyurethane resin is suitable. As such a diol compound, commercially available products such as trimethylolpropane monoallyl ether may be employed. Compounds which are easily produced by reaction of a halogenated diol compound, a triol compound or an aminodiol compound with an unsaturated group-containing carboxylic acid, acid chloride, isocyanate, alcohol, amine, thiol or halogenated alkyl compound may also be employed. Specific examples of these compounds include the following compounds, but it should not be construed that the invention is limited thereto.

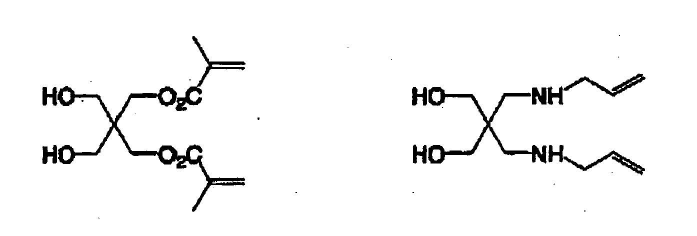

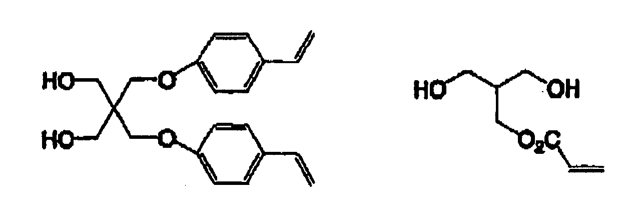

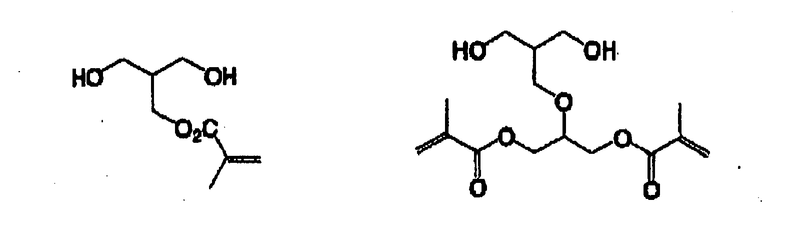

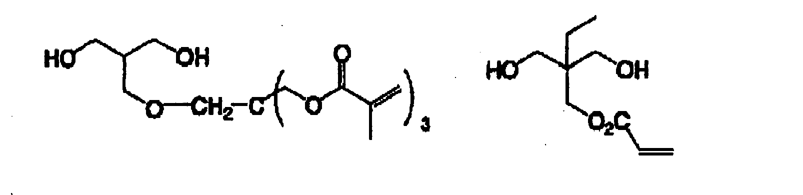

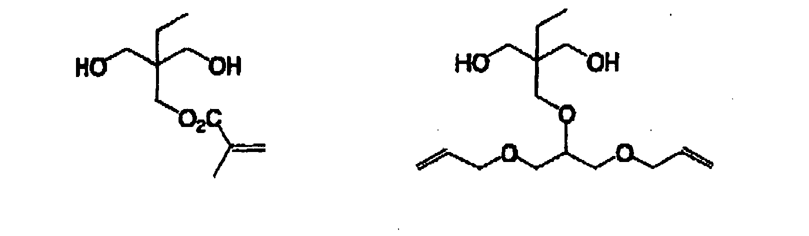

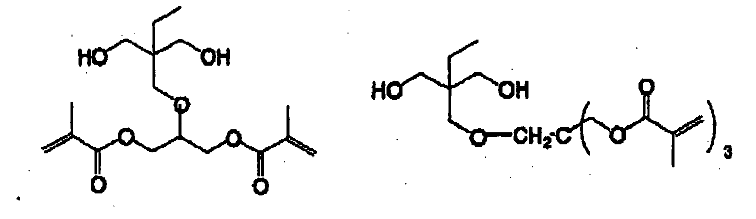

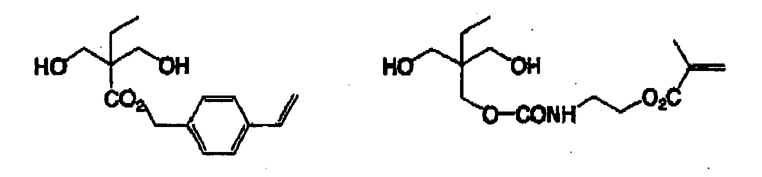

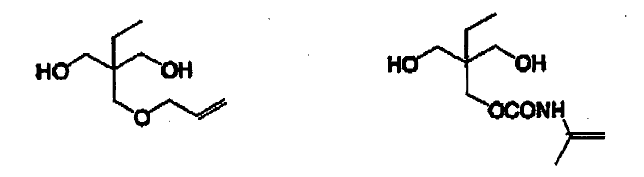

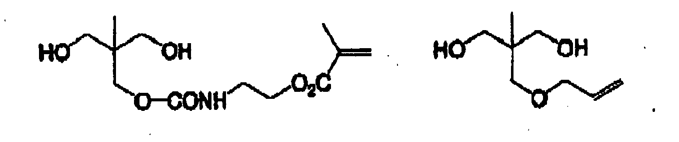

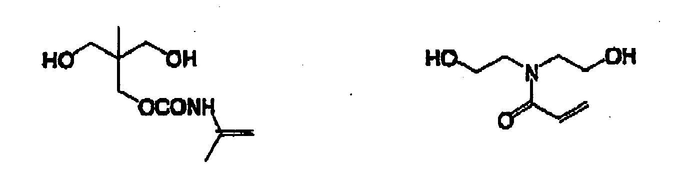

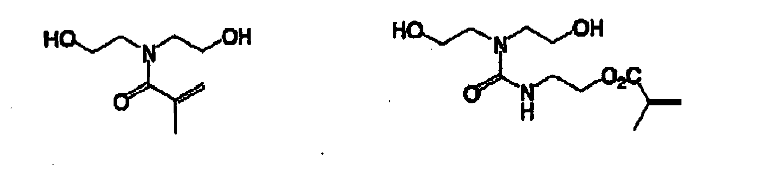

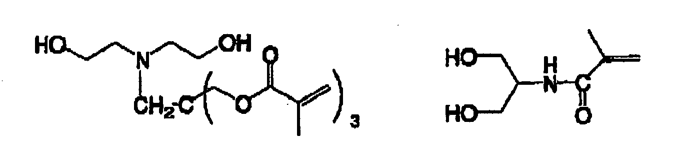

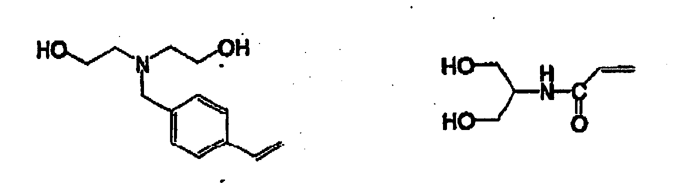

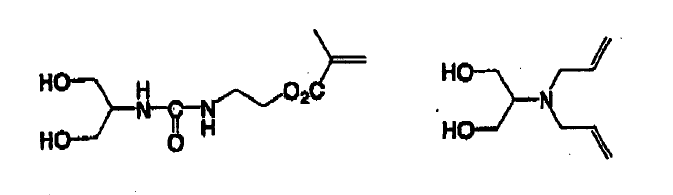

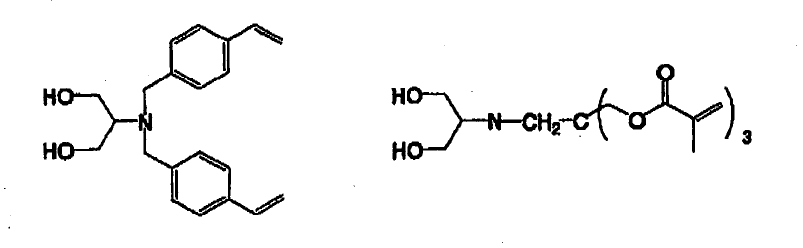

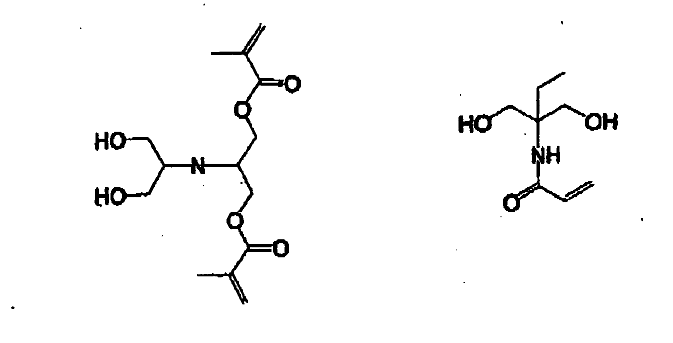

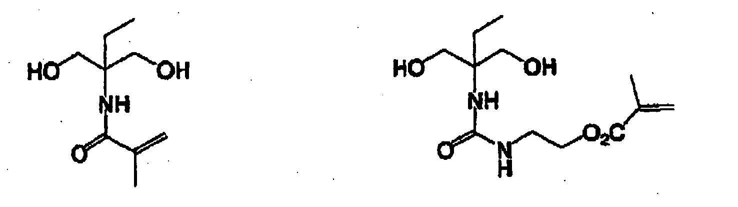

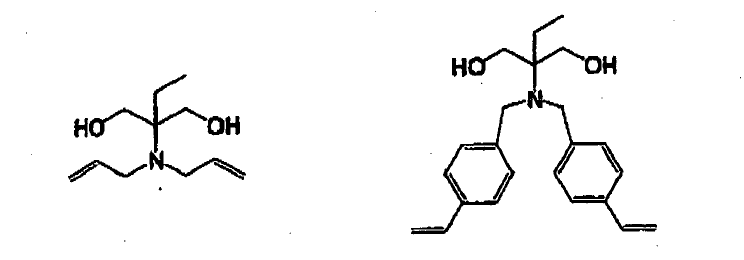

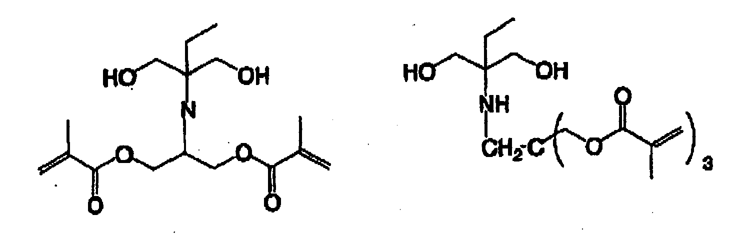

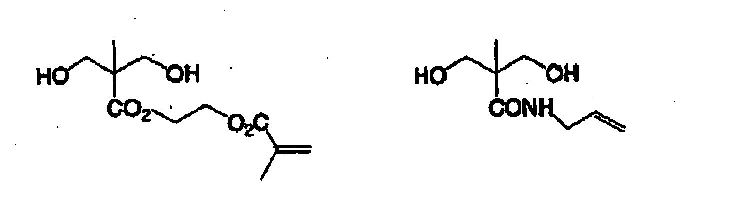

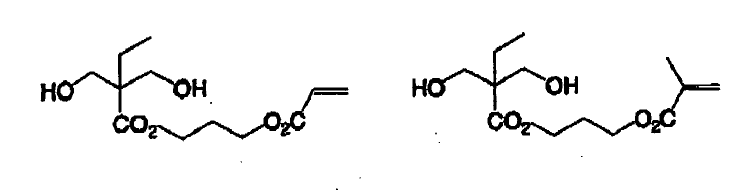

In addition, examples of still other diol compounds include ethylene glycol compounds represented by the following formula (A').

HO-(CH₂CH₂O)ₙ-H (A')

In the foregoing formula (A'), n represents an integer of 1 or more.

Furthermore, there are numerated hydroxyl group-terminated random copolymers and block copolymers of ethylene oxide and propylene oxide.

In addition, ethylene oxide adducts ofbisphenol A (the number of addition of ethylene oxide is 27 to 100), ethylene oxide adducts ofbisphenol F (the number of addition of ethylene oxide is from 22 to 100), ethylene oxide adducts of hydrogenated bisphenol A (the number of addition of ethylene oxide is from 23 to 100), and ethylene oxide adducts of hydrogenated bisphenol F (the number of addition of ethylene oxide is from 18 to 100) can be used. More specifically, ethylene glycol compounds represented by the formula (A') are preferable in view of staining properties; ethylene glycol compounds wherein n is from 2 to 50 are more preferable; ethylene glycol compounds wherein n is from 3 to 30 are further preferable; and ethylene glycol compounds wherein n is from 4 to 10 are especially preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol tri-1,3-propylene glycol, tetra-1,3-prnpylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, - 1,7-heptanediol, 1,8-octanediol, cyclohexanedimethanol tricyclodecanedimethanol, hydrogenated bisphenol A, hydrogenated bisphenol F, an ethylene oxide adduct ofbisphenol A (the number of addition of ethylene oxide is not more than 26), an ethylene oxide adduct of bisphenol F (the number of addition of ethylene oxide is not more than 21), an ethylene oxide adduct of hydrogenated bisphenol A (the number of addition of ethylene oxide is not more than 22), an ethylene oxide adduct of hydrogenated bisphenol F (the number of addition of ethylene oxide is not more than 17), a propylene oxide adduct of bisphenol A, a propylene oxide adduct ofbisphenol F, a propylene oxide adduct of hydrogenated bisphenol A, a propylene oxide adduct of hydrogenated bisphenol F, hydroquinonedihydroxyethyl ether, p-xylylene glycol, dihydroxyethylsulfone, bis(2-hydroxyethyl)-2,4-tolylene dicarbamate, 2,4-tolylene-bis(2-hydroxyethyl carbarmide), bis(2-hydroxyethyl)-m-xylylene dicarbamate, and bis(2-hydroxyethyl) isophthalate.

Polyether diol compounds of a compound represented by the formula (A), (B), (C), (D) or (E) can also be suitably used.

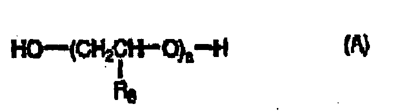

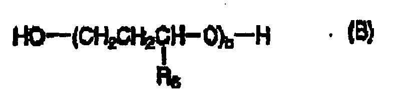

HO―(CH₂CH₂CH₂CH₂-O)_{c}―H (C)

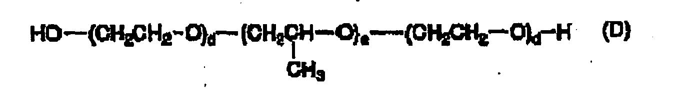

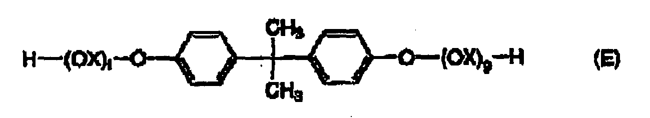

In the foregoing formulae, R₆ represents a hydrogen atom or a methyl group, provided that in the formula (A), R₆ represents a methyl group. X represents either one of the following groups:

**―CH**_{**2**}**CH**_{**2**}**―**

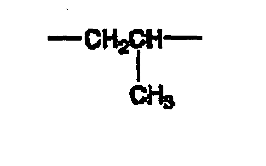

In the foregoing formulae, a, b, c, d, e, and f each represents an integer of 2 or more, and preferably an integer of from 2 to 100.

In addition, polyester diol compounds represented by the formulae (11) and (12) can be enumerated as specific examples.

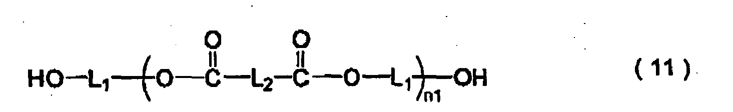

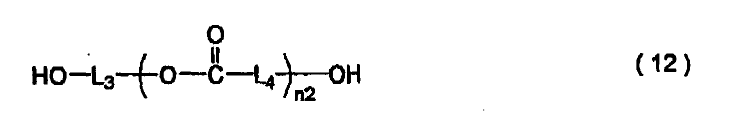

In the foregoing formulae, L₁, L₂, and L₃ may be the same or different and each a divalent aliphatic or aromatic hydrocarbon group; and L₄ represents a divalent aliphatic hydrocarbon group. Preferably, L₁, L₂, and L₃ each represents an alkylene group, an alkenylene group, an alkynylene group, or an arylene group; and L₄ represents an alkylene group, Furthermore, L₁, L₂, L₃, and L₄ may contain other functional group which does not react with the isocyanate group, such as an ether group, a carbonyl group, an ester group, a cyano group, an olefin group, a urethane group, an amide group, an ureido group, and a halogen atom. n₁ and n₂ each represents an integer of 2 or more, and preferably an integer of from 2 to 100.

In addition, polycarbonate diol compounds represented by the formula (13) can be enumerated as specific examples.

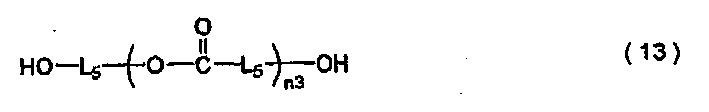

In the foregoing formula (13), L₅s may be the same or different and each represents a divalent aliphatic or aromatic hydrocarbon group. Preferably, L₅ represents an alkylene group, an alkenylene group, an alknylene group, or an arylene group. Furthermore, L₅ may contain other functional group which does not react with the isocyanate group, such as an ether group, a carbonyl group, an ester group, a cyano group, an olefin group, a urethane group, an amide group, an ureido group, and a halogen atom. n₃ represents an integer of 2 or more, and preferably an integer of from 2 to 100.

Specific examples of the diol compounds represented by the formulae (11), (12) and (13) include the following compounds. In the following specific examples, n represents an integer of 2 or more.

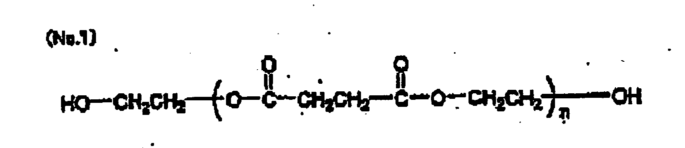

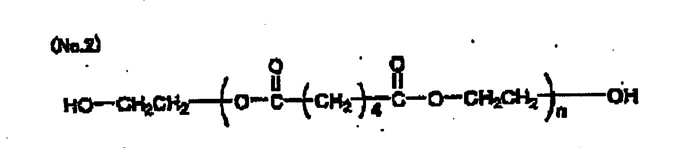

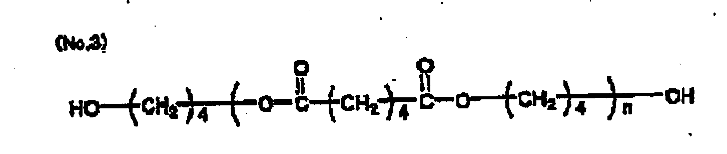

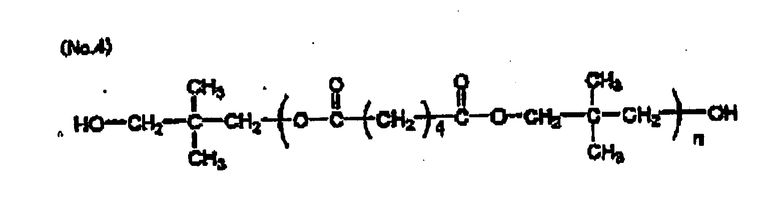

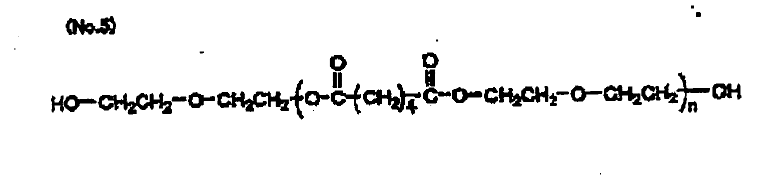

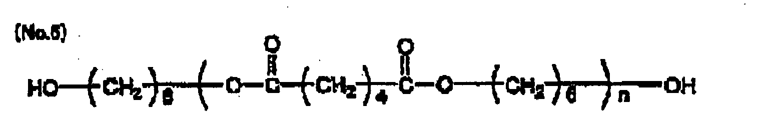

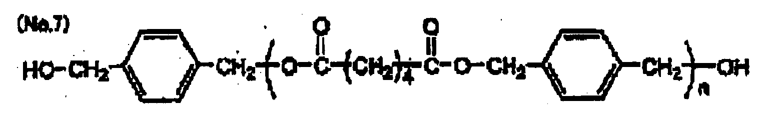

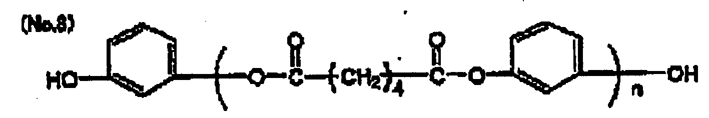

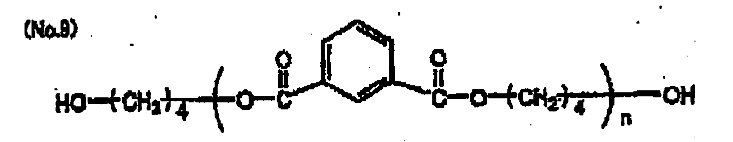

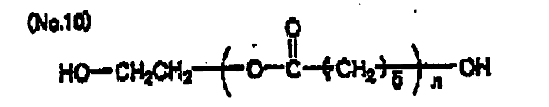

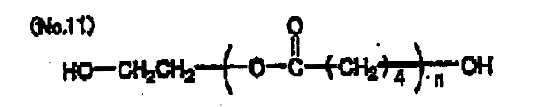

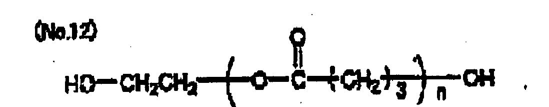

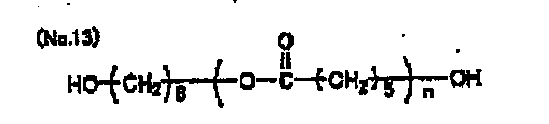

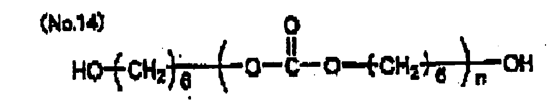

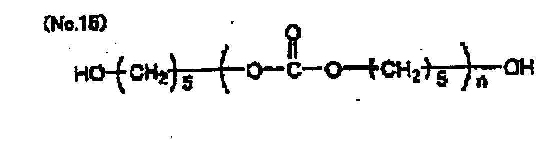

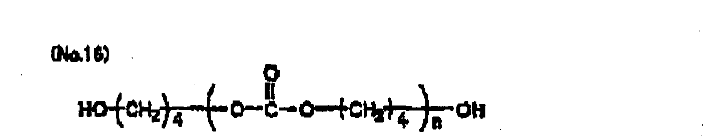

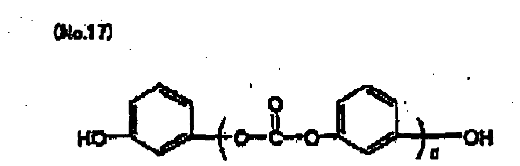

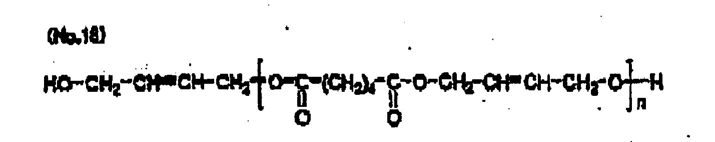

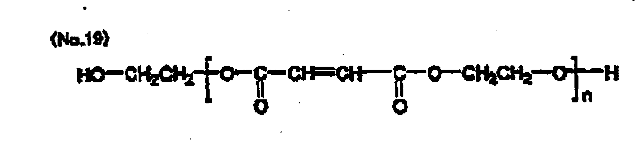

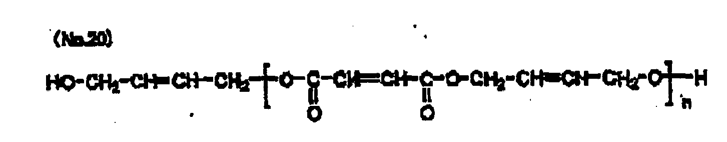

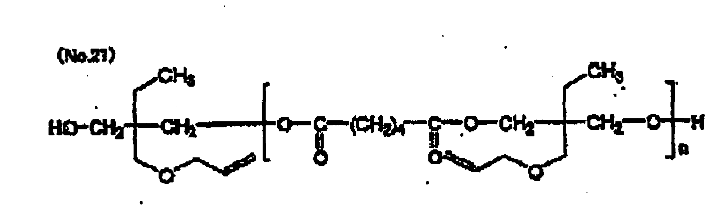

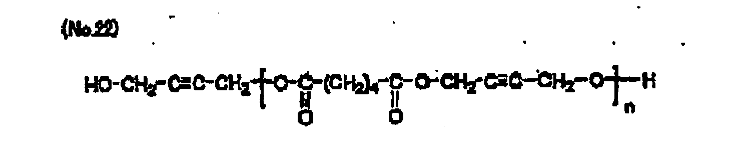

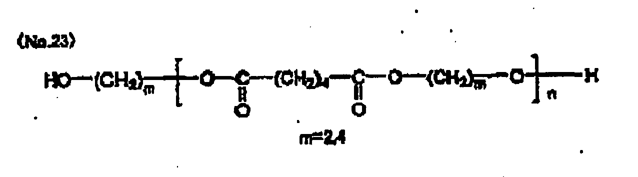

Moreover, diol compounds which do not contain a carboxyl group and may contain other substituent which does not react with the isocyanate can be used.

Such a diol compound includes the following compounds.

HO-L₆-O-CO-L₇-CO-O-L₆-OH (14)

HO-L₇-CO-O-L₆-OH (15)

In the foregoing formulae, L₆ and L₇ may be the same or different and each represents an optionally substituted divalent aliphatic hydrocarbon group, aromatic hydrocarbon group or heterocyclic group (examples of the substituent include an alkyl group, an aralkyl group, an aryl group, an alkoxy group, an aryloxy group, and a halogen atom (for example, -F, -Cl, -Br, and -I). If desired, L₆ and L₇ may each contain other functional group which does not react with the isocyanate group, such as a carbonyl group, an ester group, a urethane group, an amide group, and an ureido group. Incidentally, L₆ and L₇ may be taken together to form a ring.

Specific examples of the compound represented by the formula (14) or (15) include the following compounds.

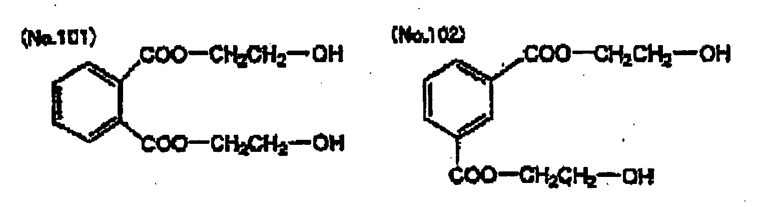

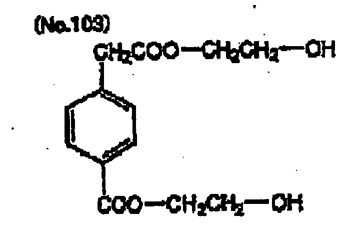

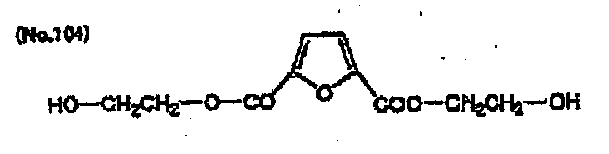

(No.105) HO―CH₂CH₂―O―CO―CH=CH―COO―CH₂CH₂―OH

(No.106) HO―CH₂CH₂―O―COC₁₁H₂₂COO―CH₂CH₂―OH

(No.107) HO―CH₂CH₂―O―COC₁₂H₂₄―COO―CH₂CH₂―OH

(No.108) HO―CH₂CH₂―O―COC₁₄H₂₈COO―CH₂CH₂―OH

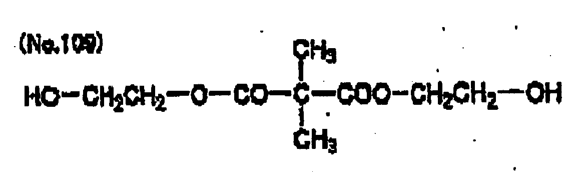

(No.110) HO―CH₂CH₂―O―CO―C≡C―COO―CH₂CH₂―OH

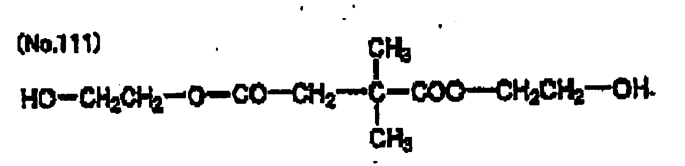

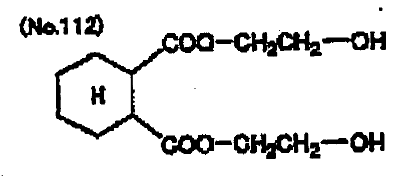

(No.113) HO―CH₂CH₂―O―CO―CH₂―O―CH₂―COO―CH₂CH₂―OH

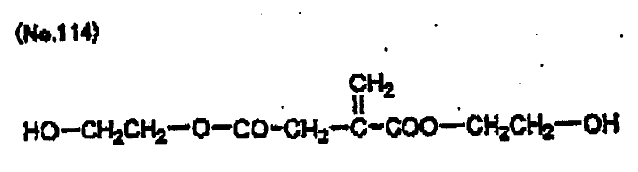

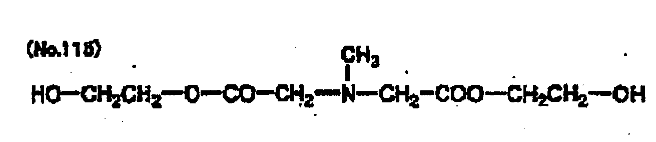

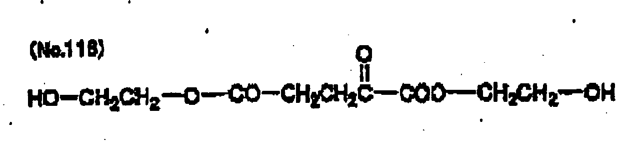

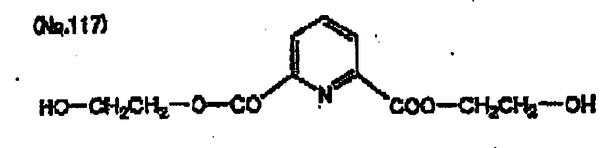

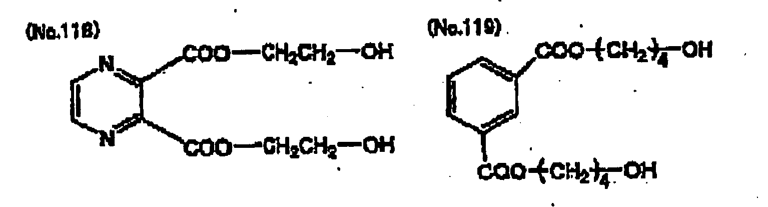

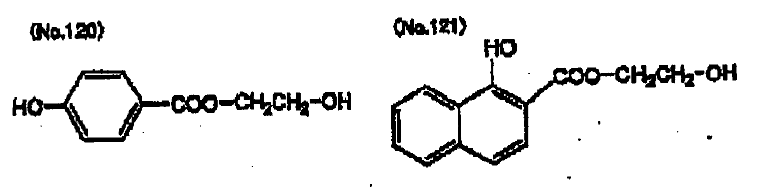

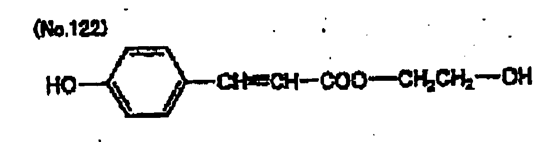

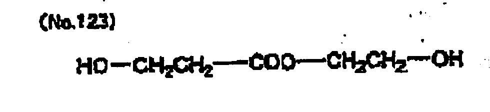

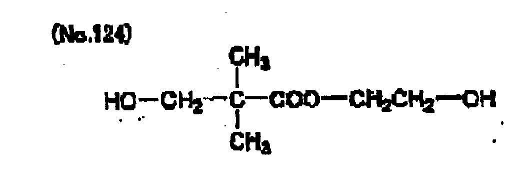

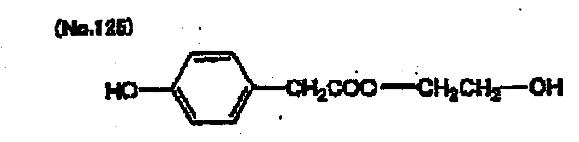

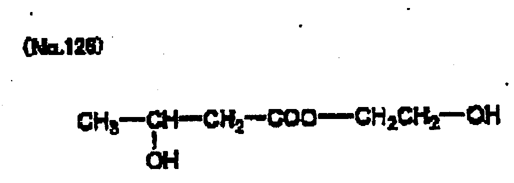

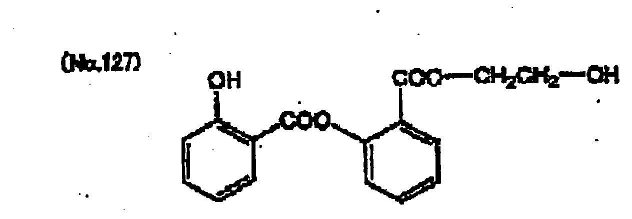

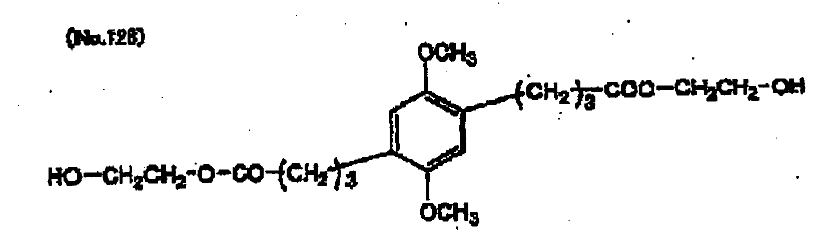

The following diol compounds can also be suitably used.

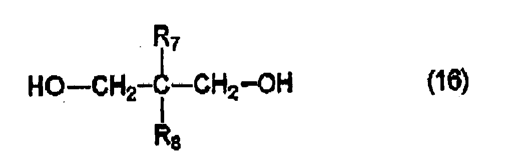

HO―CH₂-C≡C―CH₂―OH (17)

HO―CH₂―CH=CH―CH₂―OH (18)

In the foregoing formulae, R₇ and R₈ may be the same or different and each represents an optionally substituted alkyl group, and preferably an optionally substituted alkyl group having from 1 to 10 carbon atoms (examples of the substituent include a cyano group, a nitro group, a halogen atom (for example, -F, -Cl, -Br, and -I), a -CONH₂ group, -COOR group, and an -OR group (wherein Rs may be the same or different and each represents an alkyl group having from 1 to 10 carbon atoms, an aryl group having from 7 to 15 carbon atoms, or an aralkyl group)).

Specific examples of the diol compound represented by the formula (16) include the following compounds.

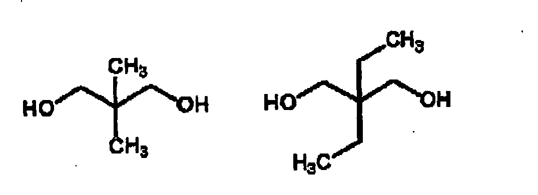

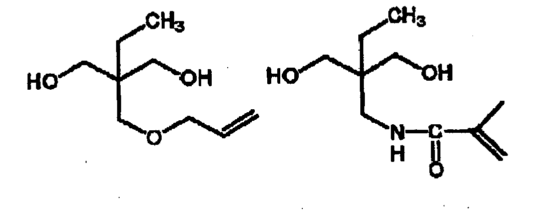

2-Butyne-1,4-diol is enumerated as the formula (17); and cis-2-butene-1,4-diol and trans-2-butene-1,4-diol are enumerated as the formula (18).

Diol compounds represented by the following formulae (19) and (20) can also be suitably used.

HO-L₈-NH-CO-L₉-CO-NH-L₈-OH (19)

HO-L₉-CO-NH-L₈-OH (20)

In the foregoing formulae, L₈ and L₉ may be the same or different and each represents an optionally substituted divalent aliphatic hydrocarbon group, aromatic hydrocarbon group or heterocyclic group (examples of the substituent include an alkyl group, an aralkyl group, an aryl group, an alkoxy group, an aryloxy group, and a halogen atom (for example, -F, -Cl, -Br, and -I)). If desired, L₈ and L₉ may each contain other functional group which does not react with the isocyanate group, such as a carbonyl group, an ester group, a urethane group, an amide group, and an ureido group. Incidentally, L₈ and L₉ may be taken together to form a ring.

Specific examples of the compound represented by the formula (19) or (20) include the following compounds.

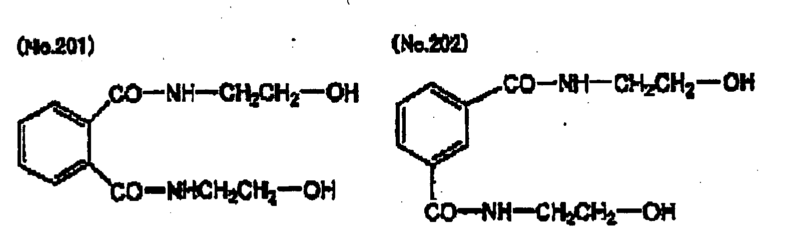

(No.203) HO―CH₂CH₂―NH―CO―CH=CH―CO―NH―CH₂CH₂―OH

(No.204) HO―CH₂CH₂―NH―CO―C=C―CO―NH―CH₂CH₂―OH

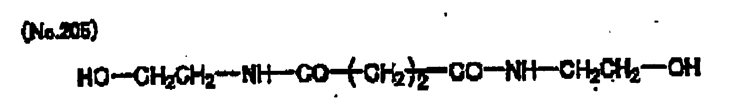

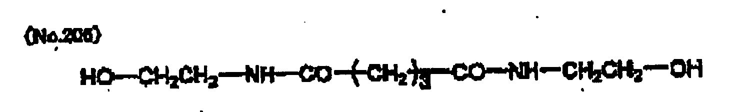

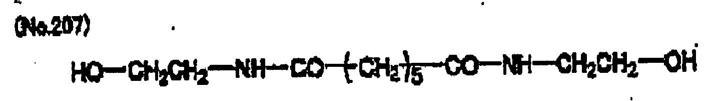

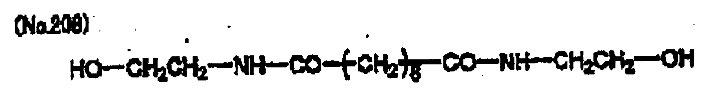

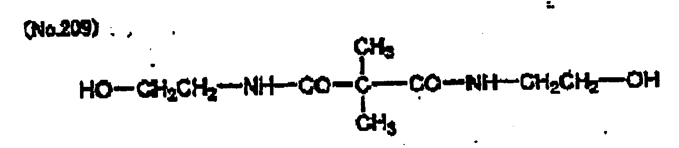

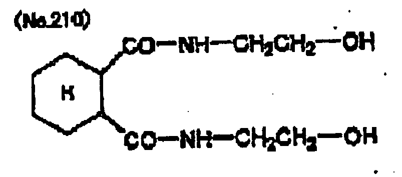

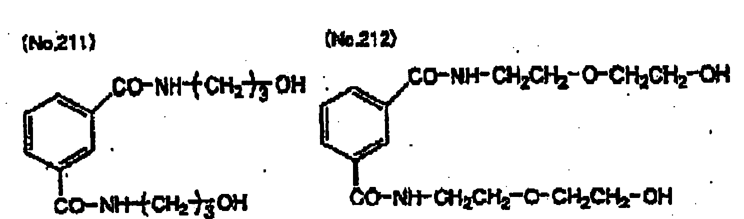

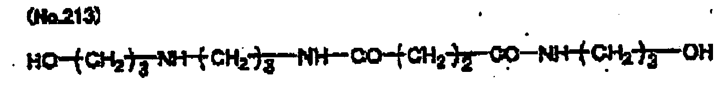

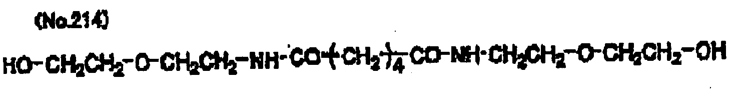

(No.215) HO―CH₂CH₂―NH―CO―CH₂―O―CH₂―CO―NH―CH₂CH₂―OH

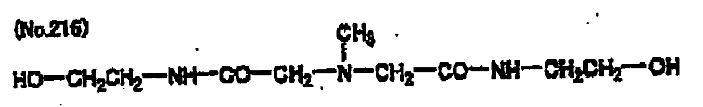

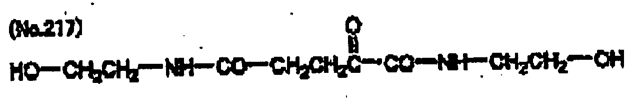

(No.218) HO―CH₂CH₂―NH―CO―CH₂―S―CH₂―CO―NH―CH₂CH₂―OH

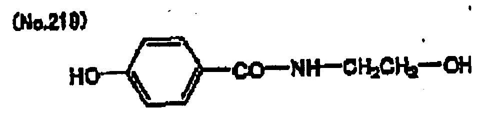

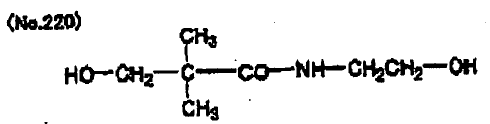

In addition, diol compounds represented by the following formulae (21) and (22) can be suitably used.

HO-Ar₂-(L₁₆-Ar₃)ₙ-OH (21)

HO-Ar₂-L₁₆-OH (22)

In the foregoing formulae, L₁₆ represents an optionally substituted divalent aliphatic hydrocarbon group (examples of the substituent include an alkyl group, an aralkyl group, an aryl group, an alkoxy goup, an aryloxy group, and a halogen atom. If desired, L₁₆ may contain other functional group which does not react with the isocyanate group, such as an ester group, a urethane group, an amide group, and an urcido group.

Ar₂ and Ar₃ may be the same or different and each represents an optionally substituted divalent aromatic hydrocarbon group, and preferably an aromatic hydrocarbon group having from 6 to 15 carbon atoms; and n represents an integer of from 0 to 10.

Specific examples of the diol compound represented by the formula (21) or (22) include the following compounds.

Namely, examples include catechol, resorcin, hydroquinone, 4-methylcatechol, 4-t-butylcatechol, 4-acetylcatechol, 3-methoxycatechol, 4-phenylcatechol, 4-methylresorcin, 4-ethylresorcin, 4-t-butylresorcin, 4-hexylresorcin, 4-chlororesorcin, 4-benzylresorcin, 4-acetylresorcin, 4-carbomethoxyresorcin, 2-methylresorcin, 5-methylresorcin, t-butylhydroduinone, 2,5-di-t-butylhydroquinone, 2,5-di-t-amylhydroquinone, tetramethylhydroquinone, tetrachlorohydroquinone, methylcarbaminohydroquione, methylureidohydroquinone, methylthiohydroquinone, benzonorbomene,3,6-dioL bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybenzyl alcohol, 4-hydroxybenzyl alcohol, 2-hydroxy-3,5-di-t-butylbenzyl alcohol, 4-hydroxy-3,5-di-t-butylbenzyl alcohol, 4-hydroxyphenethyl alcohol, 2-hydroxyethyl-4-hydroxybenzoate, 2-hydroxyethyl-4-hydroxyphenyl acetate, and resorcin mono-2-hydroxyethyl ether. The following diol compounds can also be suitably used.

### (v) Other amino group-containing compound:

In the polyurethane resin binder in the invention, a structure of a polyurethane resin as prepared by combining an amino group-containing compound represented by the following formula (31) or (32) and allowing it to react with a diisocyanate compound, thereby forming a urea structure may be incorporated.

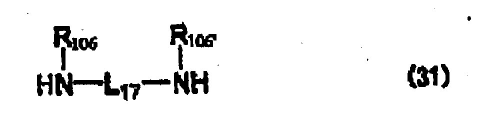

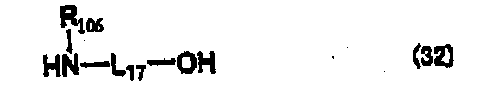

In the foregoing formulae, R₁₀₆ and R_{106'} may be the same or different and each represents a hydrogen atom or an optionally substituted alkyl, aralkyl or aryl group (examples of the substituent include an alkoxy group, a halogen atom (for example, -F, -Cl, -Br, and -I), an ester group, and a carboxyl group), and preferably a hydrogen atom or an alkyl group having from 1 to 8 carbon atoms or an aryl group having from 6 to 15 carbon atoms, each of which may contain a carboxyl group as a substituent. L₁₇ represents an optionally substituted divalent aliphatic hydrocarbon group, aromatic hydrocarbon group or heterocyclic hydrocarbon group (examples of the substituent include an alkyl group, an aralkyl group, an aryl group, an alkoxy group, an aryloxy group, a halogen atom (for example, -F, -Cl, -Br, and -I), and a carboxyl group). If desired, L₁₇ may contain other functional group which does not react with the isocyanate group, such as a carbonyl group, an ester group, a urethane group, and an amide group. Incidentally, two of R₁₀₆, L₁₇, and R_{106'} may be taken together to form a ring.

Specific examples of the compound represented by the formula (31) or (32) include the following compounds.

Namely, examples include aliphatic diamine compounds (for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6 tetraroethylpiperidine, N,N-dimethylethylenediamine, lysine, L-cystine, and isophoronediamine); aromatic diamine compounds (for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether, and 1,8-naphthalenediamine); heterocyclic amine compounds (for example, 2-aminoimidazole, 3-aminotriazole, 5-amino-1H-tetrazole, 4-aminopyrazole, 2-aminobenzimidazole, 2-amino-5-carboxy-triazole, 2,4-diamino-6-methyl-S-triazine, 2,6-diaminopyridine, L-histidine, DL-tryptophan, and adenine); and amino alcohol or amino phenol compounds (for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylannine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol, and L-tyrosine).

In addition to the foregoing polyurethane resins as obtained by introducing a crosslinking group in the side chain thereof at the time of synthesis of polyurethane, polyurethane resins as obtained by introducing a crosslinking group into a carboxyl group-containing polyurethane by polymeric reaction as described in JP-A-2003-270775 can be used as the high molecular binder according to the invention.

The molecular weight of the high molecular binder according to the invention is properly determined from the viewpoints of image forming properties and printing resistance. The molecular weight is preferably in the range of from 2,000 to 1,000,000, more preferably from 5,000 to 500,000, and further preferably from 10,000 to 200,000.

The high molecular binder which is used in the invention may be used singly or in combination of two or more kinds thereof In addition, the high molecular binder may be used jointly with one or more kinds of other crosslinking group-free binder polymer as a mixture. As the binder polymer which can be used jointly, conventionally known alkali-soluble or swelling binders can be used without limitations. Specifically, for example, acrylic-principal chain binders and urethane binders which are frequently used in the art are preferably used.

While the total sum of the high molecular binder and the binder polymer which may be used jointly in the photosensitive layer can be properly determined, it is usually in the range of from 10 to 90 % by weight, preferably from 20 to 80 % by weight, and more preferably from 30 to 70 % by weight based on the total weight of non-volatile components in the photosensitive layer.

As the (meth)acrylic resin containing a crosslinking group in the side chain thereof which is used in the invention, a resin containing a repeating unit represented by the following formula (i) is preferable from the viewpoint of developability.

The resin containing a repeating unit represented by the formula (i) will be hereunder properly referred to as a "specific (meth)acrylic resin" and described below in detail.

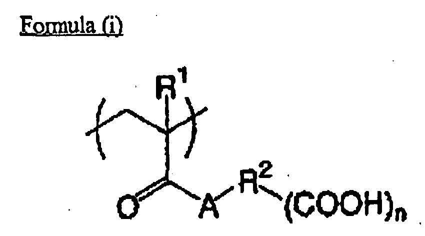

In the foregoing formula (i), R¹ represents a hydrogen atom or a methyl group; R² represents a connecting group constituted of one or more atoms selected from the group consisting of a carbon atom, a hydrogen atom, an oxygen atom, a nitrogen atom, and a sulfur atom; A represents an oxygen atom or -NR³-; R³ represents a hydrogen atom or a monovalent hydrocarbon group having from 1 to 10 carbon atoms; and n represents an integer of from 1 to 5.

First of all, R¹ in the formula (i) represents a hydrogen atom or a methyl group, and especially preferably a methyl group.

The connecting group represented by R² in the formula (i) is constituted of one or more atoms selected from the group consisting of a carbon atom, a hydrogen atom, an oxygen atom, a nitrogen atom, and a sulfur atom, and it is preferable that the number of atoms exclusive of its substituent is from 2 to 82. Specifically, the number of atoms constituting the principal skeleton of the connecting group represented by R² is preferably from 1 to 30, more preferably from 3 to 25, further preferably from 4 to 20, and most preferably from 5 to 10. Incidentally, the term "principal skeleton of the connecting group" as referred to in the invention refers to atoms or an atomic group to be used only for connecting A to the terminal COOH in the formula (i); and in particular, when plural connecting routes are present, this term refers to atoms or an atomic group for constituting a route where the number of atoms to be used is the smallest. Accordingly, in the case where a cyclic structure is contained in the connecting group, the number of atoms to be counted varies depending upon its connecting site (for example, o-, m-, and p-).

Furthermore, more specifically, examples of the connecting group include an alkylene, a substituted alkylene, an arylene, and a substituted arylene. The connecting group may have a structure in which a plural number of such divalent groups are connected to each other via an amide bond or an ester bond.

Examples of the connecting group of a chain structure include ethylene and propylene. Structures in which such alkylenes are connected to each other via an ester bond can also be enumerated as a preferred structure.

Above all, it is preferable that the connecting group represented by R² in the formula (i) is a hydrocarbon group having a valence of (n + 1) and having an aliphatic cyclic structure having from 3 to 30 carbon atoms. More specifically, a hydrocarbon group having a valence of (n + 1) resulting from elimination of (n + 1) hydrogen atoms on arbitrary carbon atoms constituting a compound having an aliphatic cyclic structure, which may be substituted with one or more arbitrary substituents, such as cyclopropane, cyclopentane, cyclohexane, cycloheptane, cyclooetane, cyclodecane, dicyclohexyl, tercyclohexyl, and norbornane can be enumerated. Furthermore, it is preferable that R² has from 3 to 30 carbon atoms including the substituent.

One or more arbitrary carbon atoms of a compound constituting an aliphatic cyclic structure may be substituted with a hetero atom selected from a nitrogen atom, an oxygen atom, and a sulfur atom. In view of printing resistance, R² is preferably a hydrocarbon group having a valence of (n + 1) and having an optionally substituted aliphatic cyclic structure, which has from 5 to 30 carbon atoms and contains two or more rings, such as fused polycyclic aliphatic hydrocarbons, crosslinked alicyclic hydrocarbons, spiro aliphatic hydrocarbons, and aliphatic hydrocarbon ring agglomerations (in which plural rings are connected to each other via a bond or a connecting group). In this case, the number of carbon atoms is one including the number of carbon atoms which the substituent has, too.

As the connecting group represented by R², a connecting group having the number of atoms constituting the principal skeleton of the connecting group of from 5 to 10 is preferable. With respect to the structure, a connecting group having a chain structure and containing an ester bond in the structure thereof and a connecting group having the foregoing cyclic structure are preferable.

As the substituent which can be introduced into the connecting group represented by R², a monovalent non-metallic atomic group excluding hydrogen can be enumerated. Examples thereof include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylactylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylurr,ido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycabonylamino group, an aryl-N-alkoxycarbonylamino group, an N-aryl-N-aryloxycarbonylanvno group, a formyl group, an acyl group, a carboxyl group and its conjugated base group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and its conjugated base goup, an N-alkylsulfonylsulfamoyl group (-SO₂NHSO₂(alkyl)) and its conjugated base group, an N-arylsulfonylsulfamoyl group (-SO₂NHSO₂(aryl)) and its conjugated base group, an N-alkylsulfonylcarbamoyl group (-CONHSO₂(alkyl)) and its conjugated base group, an N-arylsulfonylcarbamoyl group (-CONHSO₂(aryl)) and its conjugated base group, an alkoxysilyl group (-Si(Oalkyl)₃), an aryloxysilyl group (-Si(Oaryl)₃), a hydroxysilyl group (-Si(OH)₃) and its conjugated base group, a phosphono group (-PO₃H₂) and its conjugated base group, a dialkylphosphono group (-PO₃(alkyl)₂), a diarylphosphono group (-PO₃(aryl)₂), an alkylarylphosphono group (-PO₃₋(alkyl)(aryl)), a monoalkylphosphono group (-PO₃H(alkyl)) and its conjugated base group, a monoarylphosphono group (-PO₃H(aryl)) and its conjugated base group, a phosphonoxy group (-OPO₃H₂) and its conjugated base group, a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and its conjugated base group, a monoarylphosphonoxy group (-OPO₃H(aryl)) and its conjugated base group, a cyano group, a nitro group, a dialkylboryl group (-B(alkyl)₂), a diarylboryl group (-B(aryl)₂), an alkylarylboryl group (-B(alkyl)(aryl)), a dihydroxyboryl group (-B(OH)₂) and its conjugated base group, an alkylhydroxyboryl group (-B(alkyl)(OH)) and its conjugated base group, an arylhydroxybaryl group (-B(aryl)(OH)) and its conjugated base group, an aryl group, an alkenyl group, and an alkynyl group.

In the photosensitive lithographic printing plate of the invention, a hydrogen-containing substituent which can undergo hydrogen bonding, and especially an acidic substituent having an acid dissociation constant (pKa) lower than carboxylic acids are not preferable because they are liable to lower the printing resistance, an aspect of which, however, varies depending upon the design of the photosensitive layer. On the other hand, a halogen atom and a hydrophobic substituent such as a hydrocarbon group (for example, an alkyl group, an aryl group, an alkenyl group, and an alkynyl group), an alkoxy group, and an aryloxy group are preferable because they are liable to enhance the printing resistance. In particular, in the case where the cyclic structure is a monocyclic aliphatic hydrocarbon constructed of not more than 6 members, such as cyclopentane and cyclohexane, it is preferable that such a hydrophobic substituent is contained. If possible, such substituents may be taken together or bonded to a hydrocarbon group as substituted to form a ring. The substituent may be further substituted.

When A in the formula (i) is NR³-, R³ represents a hydrogen atom or a monovalent hydrocarbon group having from 1 to 10 carbon atoms. Examples of the monovalent hydrocarbon group having from 1 to 10 carbon atoms as represented by R³ include an alkyl group, an aryl group, an alkenyl group, and an alkynyl group.

Specific examples of the alkyl group include linear, branched or cyclic alkyl groups having from 1 to 10 carbon atoms such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a I-methylbutyl group, an isohexyl group, a 2 ethylhexyl group, a 2-methylhexyl group, a cyclopentyl group, a cyclohexyl group, a 1-adamantyl group, and a 2-norbornyl group.

Specific examples of the aryl group include aryl groups having from 1 to 10 carbon atoms (for example, a phenyl group, a naphthyl group, and an indenyl group) and heteroaryl groups having from 1 to 10 carbon atoms and containing one hetero atom selected from the group consisting of a nitrogen atom, an oxygen atom, and a sulfur atom (for example, a furyl group, a thienyl group, a pyrrolyl group, a pyridyl group, and a quinolyl group).

Specific examples of the alkenyl group include linear, branched or cyclic alkenyl groups having from 1 to 10 carbon atoms such as a vinyl group, a 1-propenyl group, a 1-butenyl group, a 1-methyl-1-propenyl group, a 1-cyclopentenyl group, and a 1-cyclohexenyl group.

Specific examples of the alkynyl group include alkynyl groups having from 1 to 10 carbon atoms such as an ethynyl group, a 1-propynyl group, a 1-butynyl group, and a 1-octynyl group. The substituent which R³ may contain is the same as the substituent which R² can introduce. However, the number of carbon atoms of R³ is from 1 to 10 inclusive of the number of carbon atoms of the substituent.

A in the formula (i) is preferably an oxygen atom or -NH- because of easiness of the synthesis.
n in the formula (i) represents an integer of from 1 to 5, and preferably 1 in view of printing resistance.

Preferred specific examples of the repeating unit represented by the formula (i) will be given below, but it should not be construed that the invention is limited thereto.

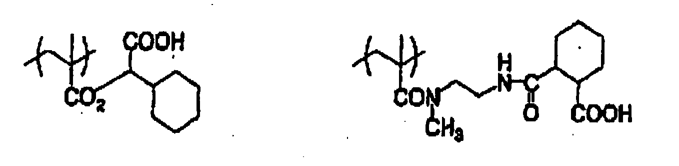

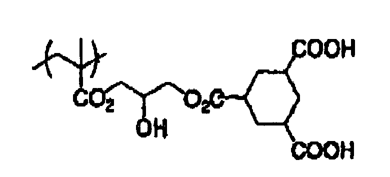

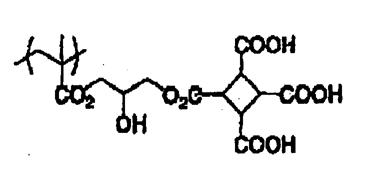

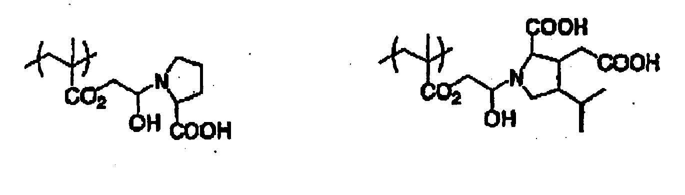

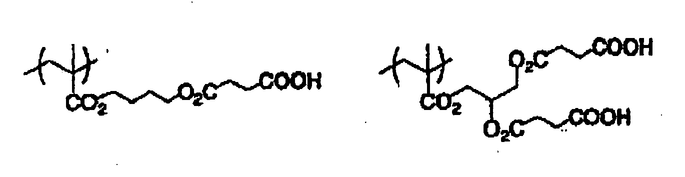

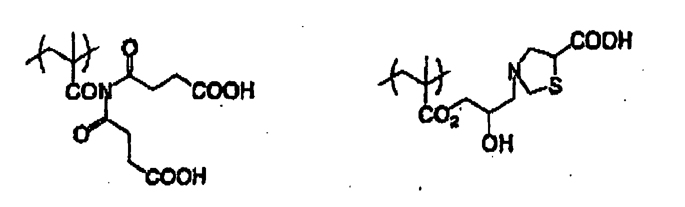

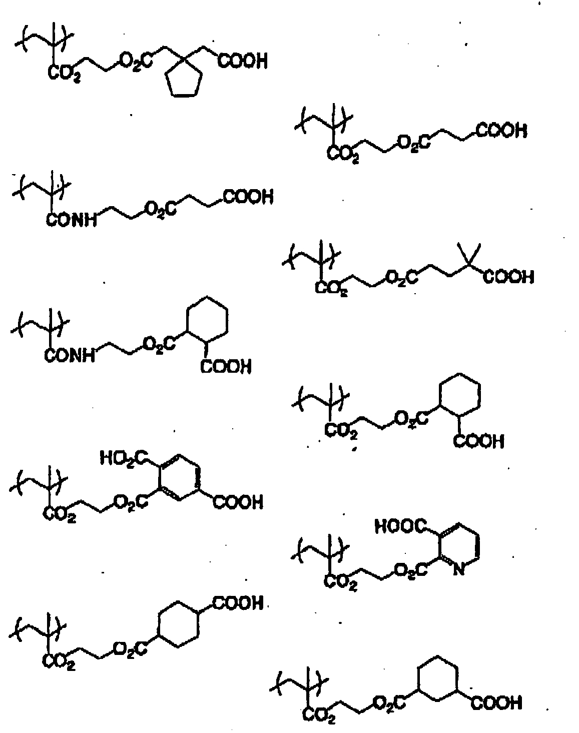

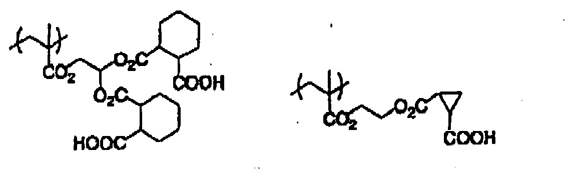

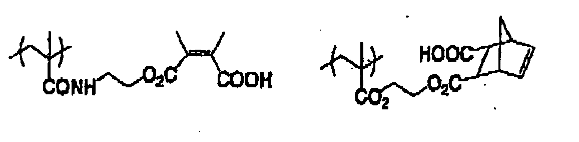

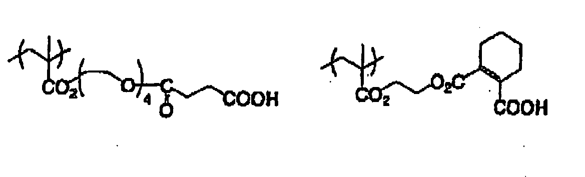

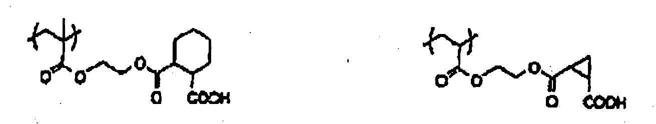

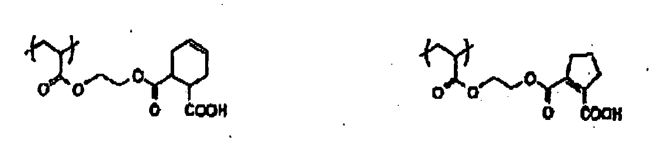

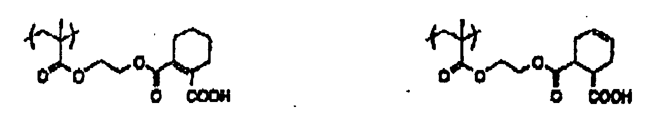

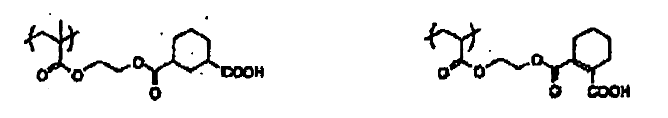

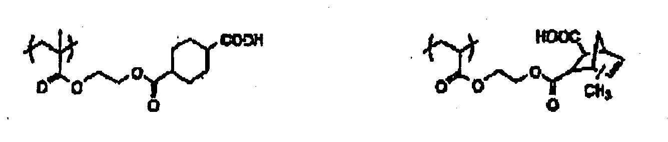

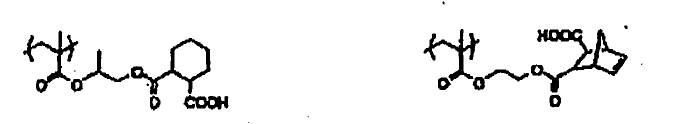

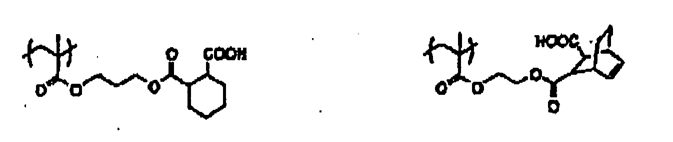

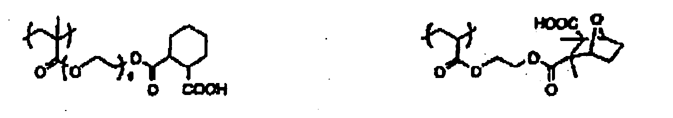

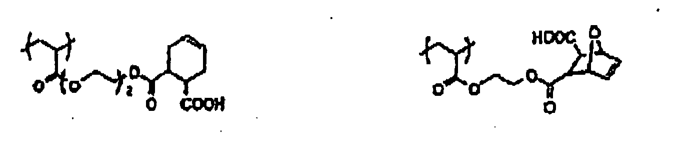

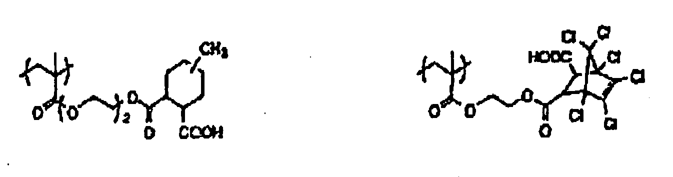

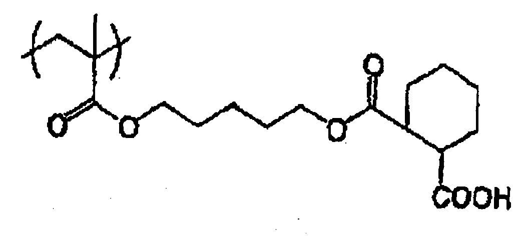

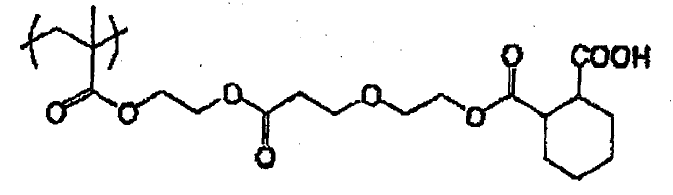

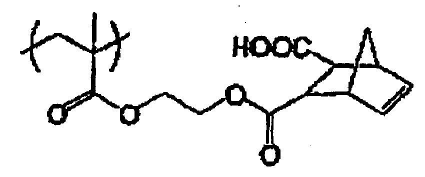

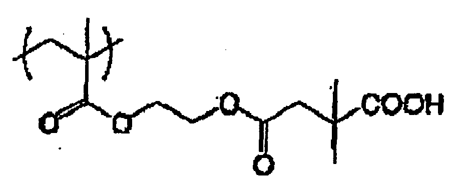

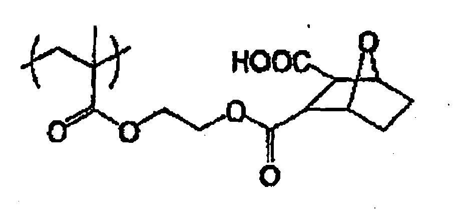

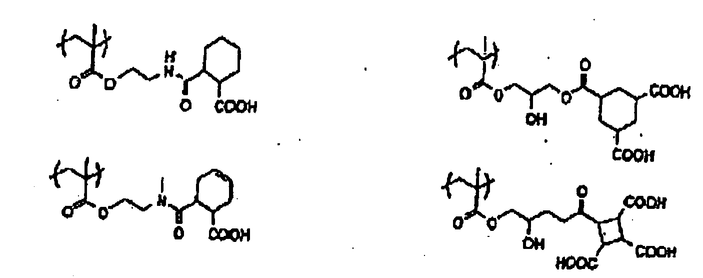

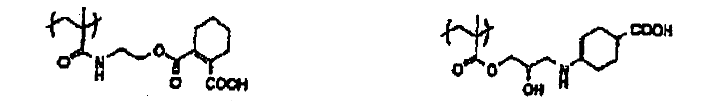

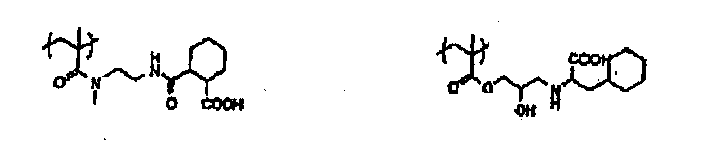

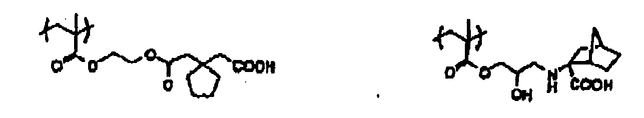

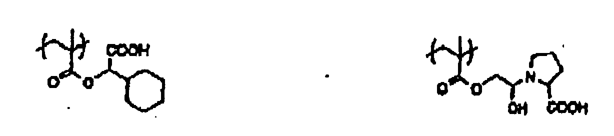

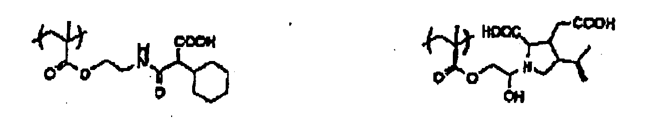

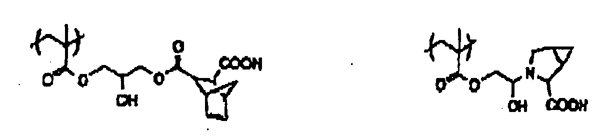

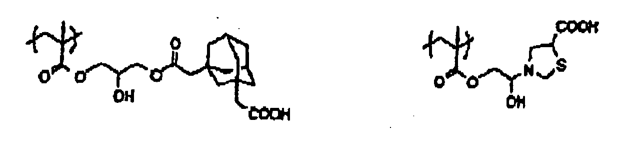

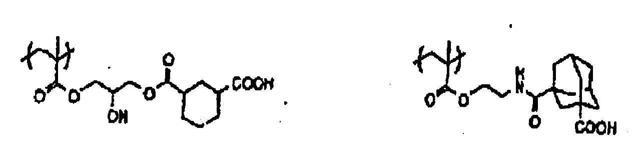

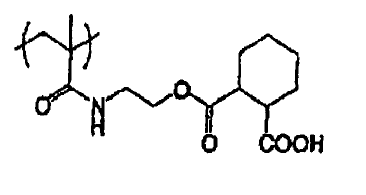

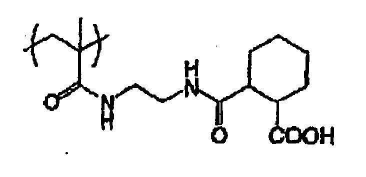

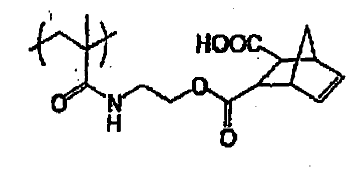

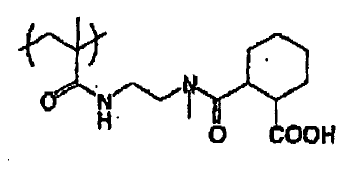

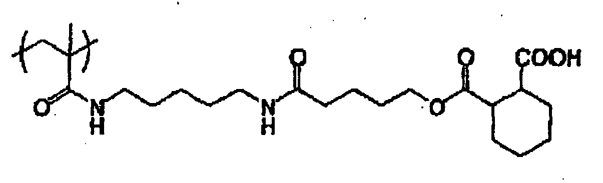

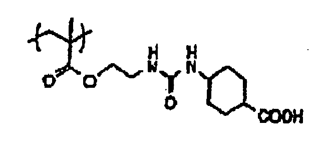

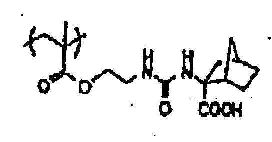

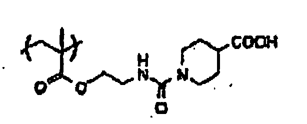

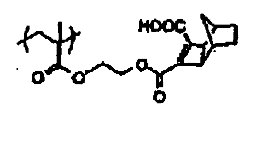

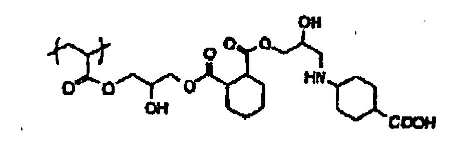

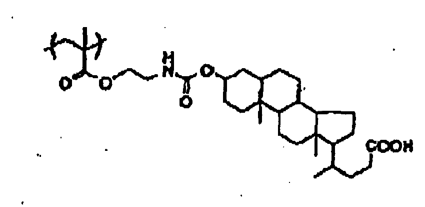

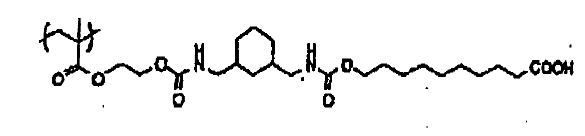

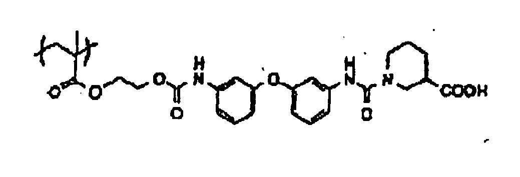

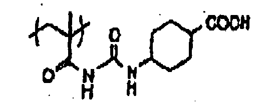

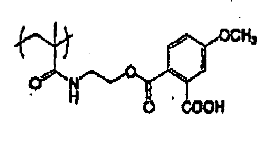

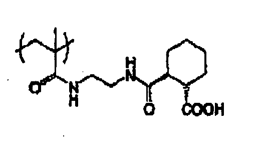

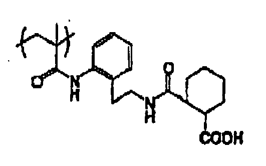

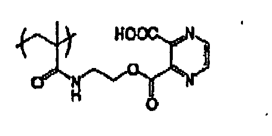

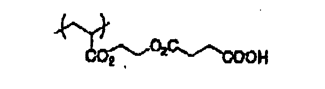

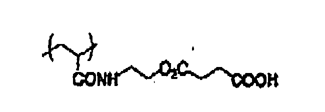

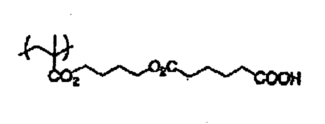

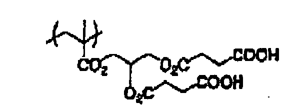

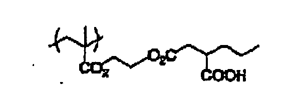

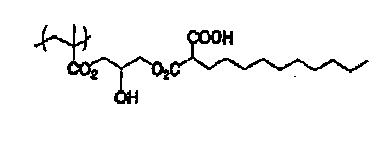

The repeating unit represented by the formula (i) may be contained singly, or two or more kinds thereof may be contained in the specific (meth)acrylic resin. While the specific (meth)acrylic resin in the invention may be a resin composed only of the repeating unit represented by the formula (i), it is usually combined with other copolymerization component and used as a copolymer. The total content of the repeating unit represented by the formula (i) in the copolymer is properly determined by its structure, the design of the photopolymerizable composition, and the like. The repeating unit represented by the formula (i) is contained preferably in an amount ranging from 1 to 99 % by mole, more preferably from 5 to 40 % by mole, and further preferably from 5 to 20 % by mole based on the whole molar amount of the resin components.

As the copolymerization component, conventionally known monomers can be used without limitations so far as they are a radical polymerizable monomer. Specifically, there are enumerated monomers as described in *Kobunshi Deta Handobukku: Kiso-Hen* "Polymer Handbook: Basic Edition" (edited by The Society of Polymer Science, Japan and published by Baifukan Co., Ltd., 1986). Such copolymerization components may be used singly or in combination of two or more kinds thereof

The weight average molecular weight of the specific (meth)acrylic resin in the invention is properly determined from the viewpoints of image forming properties and printing resistance. The weight average molecular weight is preferably in the range of from 2,000 to 1,000,000, more preferably from 5,000 to 500,000, and further preferably from 10,000 to 200,000.

Though the amount of the crosslinking group-containing high molecular binder in the photopolymerizable composition can be properly determined, it is usually in the range of from 10 to 90 % by weight, preferably from 20 to 80 % by weight, and more preferably from 30 to 70 % by weight based on the total weight of non-volatile components in the photopolymerizable composition.

Furthermore, the weight ratio of the photopolymerizable ethylenically unsaturated bond-containing compound to the crosslinking group-containing high molecular binder is preferably in the range of from 1/9 to 9/1, more preferably from 2/8 to 8/2, and further preferably from 3/7 to 7/3.

As the binder, one or more kinds of other resins may be used jointly with the crosslinking group-containing high molecular binder.

The resin to be used jointly is used generally in an amount of not more than 50 % by weight, and preferably not more than 30 % by weight based on the weight of the crosslinking group-containing high molecular binder.

### [Photopolymerization initiator (c)]

The photosensitive layer of the photosensitive lithographic printing plate of the invention contains a hexaaryl biimidazole as a photopolymerization initiator.

As the hexaaryl biimidazole, a variety of compounds can be used. Examples thereof include lophine dimers as described in JP-B-45-37377 and JP-B-44-86516, for example, 2,2'-bis(o-chlorophenyl)-4,4',5,5'-tetraphenyl biimidazole, 2,2'-bis-(o-bromophenyl)-4,4',5,5'-tetraphenyl biimidazole, 2,2'-bis(o,p-dichlorophenyl)-4,4',5,5'-tetraphenyl biimidazole, 2,2'-bis(o-chlorophenyl)-4,4',5,5'-tetra(m-methoxyphenyl) biimidazole, 2,2'-bis(o,o'-dichlorophenyl)-4,4',5,5'-tetraphenyl biimidazole, 2,2'-bis(o-nitrophenyl)-4,4',5,5'-tetraphenyl biimidazole, 2,2'-bis(o-methylphenyl)-4,4',5,5'-tetraphenyl biimidazole, and 2,2'-bis(o-trifluorophenyl)-4,4',5,5'-tetraphenyl biimidazole.

The amount of addition of the hexaaryl biimidazole compound to be used is generally in the range of from 0.05 to 50 % by weight, preferably from 0.1 to 20 % by weight, and more preferably from 1 to 15 % by weight based on the total weight of non-volatile components in the photopolymerizable composition.

In addition, it is possible to further enhance the photoinitiation ability by adding a hydrogen donating compound such as thiol compounds (for example, 2-mercaptobenzthiazole, 2-mercaptobenzimidazole, and 2-mercaptobenzoxazole) and amine compounds (for example, N-phenylglycine and N,N-dialkylamino aromatic alkyl esters) to the foregoing photopolymerization initiator as the need arises.

In the case of joint use, the amount of the photopolymerization initiator (system) to be used jointly is generally from 1 to 50 % by weight, and preferably from 5 to 20 % by weight based on the amount of addition of the hexaaryl biimidazole compound.

### [Cosensitizer]

By using a certain kind of an additive (hereinafter referred to as "cosensitizer"), it is possible to further enhance the sensitivity of the photosensitive layer. While these action mechanisms thereof are not always elucidated yet, it may be considered that the majority thereof is based on the following chemical process.

Namely, it is assumed that a variety of intermediate active species (for example, radicals, peroxides, oxidizing agents, and reducing agents) as generated during the photoreaction which is started due to light absorption of the foregoing photoinitiation system and the addition polymerization reaction to be subsequently achieved react with the cosensitizer to generate a new active radical.

The cosensitizer is roughly classified into the following classes (a) to (c), but in many case, there is no commonly accepted theory on what class the individual compound belongs to.
(a) Compound capable of generating an active radical upon reduction;
(b) Compound capable of generating an active radical upon oxidation; and
(c) Compound which reacts with a radical having low activity, whereby it is converted into a radical having higher activity or acts as a chain transfer agent.

### (a)Compound capable of generating an active radical upon reduction

### Compounds having a carbon-halogen bond

It is considered that a carbon-halogen bond is reductively cleaved to generate an active radical. Specifically, for example, trihalomethyl-s-triazines and trihalomethyl oxadiazoles can be suitably used.

### Compounds having a nitrogen-nitrogen bond

It is considered that a nitrogen-nitrogen bond is reductively cleaved to generate an active radical.

### Compounds having an oxygen-oxygen bond

It is considered that an oxygen-oxygen bond is reductively cleaved to generate an active radical. Specifically, for example, organic peroxides are suitably used.

### Onium compounds

It is considered that a carbon-hetero bond or an oxygen-nitrogen bond is reductively cleaved to generate an active radical. Specifically, for example, diaryl iodonium salts, triaryl sulfoniuxn salts, and N-alkoxypyridium (azinium) salts are suitably used.

### Ferrocene and iron-allene complexes

An active radical can be reductively generated.

### (b) Compound capable of generating an active radical upon oxidation

### Alkylate complexes

It is considered that a carbon-hetero bond is oxidatively cleaved to generate an active radical. Specifically, for example, triarylalkyl borates are suitably used.

### Alkylamine compounds

It is considered that a C-X bond on the carbon adjacent to nitrogen is cleaved due to oxidation to generate an active radical. X is suitably a hydrogen atom, a carboxyl group, a trimethylsilyl group, a benzyl group, etc. Specific examples of the alkylamine compound include ethanolamines, N-phenylglycines, and N-trimethylsilylxnethylanilines.

### Sulfur-containing and tin-containing compounds

Ones resulting from substitution of the nitrogen atom of the foregoing amine with a sulfur atom or a tin atom can generate an active radical due to a similar action. It is also known that a compound having an S-S bond causes sensitization due to S-S cleavage.

### α-Substituted methylcarbonyl compounds

An active radical can be generated due to bond cleavage between carbonyl and α-carbon upon oxidation. Ones resulting from conversion of the carbonyl into oxime ether exhibit a similar action. Specific examples of the compound include 2-alkyl-1-[4-(alkylthio)phenyl]-2-morpholinopropanone-1 compounds and oxime ethers obtained by allowing such a compound to react with a hydroxylamine and then etherifying the N-OH.

### Sulfinic acid salts

An active radical can be reductively generated. Specific examples thereof include sodium arylsulfinates.

### (c) Compound which reacts with a radical, whereby it is converted into a radical having higher activity or acts as a chain transfer agent

For example, compound groups having SH, PH, SiH, or GeH in the molecule thereof are used. These compounds can generate a radical by donating hydrogen to a radical species having low activity, or can generate a radical upon oxidation and then proton elimination. Specifically, there are enumerated 2-mercaptobenzimidazoles.

A number of more specific examples of the cosensitizer are described as additives for the purpose of enhancing the sensitivity in, for example, JP-A-9-236913. A part of such specific examples will be given below, but it should not be construed that the invention is limited thereto. Incidentally, -TMS represents a trimethylsilyl group.

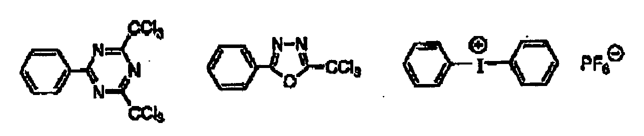

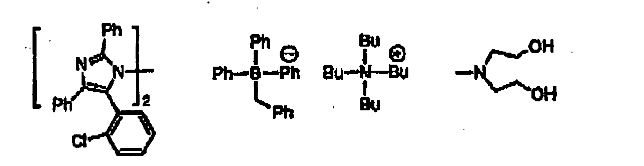

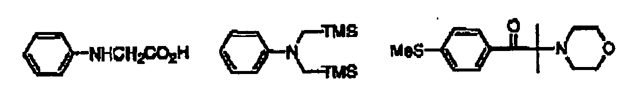

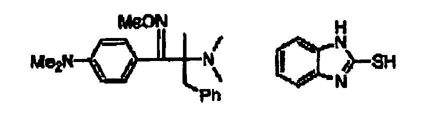

With respect to the cosensitizer, it is possible to carry out various chemical modifications for the purpose of improving characteristics of the photosensitive layer.

The cosensitizer can be used singly or in combination of two or more kinds thereof.

The amount of the cosensitizer to be used is usually in the range of from 0.05 to 100 parts by weight, preferably from 1 to 80 parts by weight, and more preferably from 3 to 50 parts based on 100 parts by weight of the ethylenically unsaturated bond-containing compound.

### [Thermal polymerization inhibitor]

Furthermore, in the invention, in addition to the foregoing basic components, it is desired to add a small amount of a thermal polymerization inhibitor during the production or storage of the photopolymerizable composition for the purpose of preventing unnecessary thermal polymerization of the polymerizable ethylenically unsaturated bond-containing compound from occurring. Examples of a suitable thermal polymerization inhibitor include hydroquinone, p-methoxyphenol, di-t-butyl-p-cresol, pyrogallol, t-butyl chatecol, benzoquinone, 4,4'-thiobis(3-methyl-6-t-butylphenol), 2,2'-methylenebis-(4-methyl-6-t-butylphenol), N-nitrosophenylhydroxylamine cerous salt, and N-nitrosophenylhydroxylamine aluminum salt.

The amount of addition of the thermal polymerization inhibitor is preferably from about 0.01 % by weight to about 5 % by weight based on the whole of solids constituting the photosensitive layer. Furthermore, if desired, for the purpose of preventing polymerization hindrance due to oxygen, a higher fatty acid derivative such as behenic acid and behenic amide may be added, thereby unevenly distributing it on the surface of the photosensitive layer during a drying step to be carried out after coating. The amount of addition of the higher fatty acid derivative or the like is preferably from about 0.5 % by weight to about 10 % by weight based on the whole of solids constituting the photosensitive layer.

### [Other additives]

In addition, for the purpose of coloring the photosensitive layer, a coloring agent may be added. Examples of the coloring agent include pigments (for example, phthalocyanine based pigments (for example, C.I. Pigment Blue 15:3, C.I. Pigment Blue 15:4, and C.I. Pigment Blue 15:6), azo based pigments, carbon black, and titanium oxide) and dyes (for example, Ethyl Violet, Crystal Violet, azo based dyes, anthraquinone based dyes, and cyanine based dyes). The amount of addition of the dye or pigment is preferably from about 0.5 % by weight to about 20 % by weight of the entire composition. In addition, for the purpose of improving physical properties of the cured film, additives such as an inorganic filler and a plasticizer (for example, dioctyl phthalate, dimethyl phthalate, and tricresyl phosphate) may be added. The amount of addition of such an additive is preferably not more than 10 % by weight of the entire composition.

### (Support)

In order to obtain a lithographic printing plate, an aspect of which is one of the principal objects of the invention, the foregoing photosensitive layer is provided on a support, the surface of which is hydrophilic. As the hydrophilic support, conventionally known hydrophilic supports which are useful in lithographic printing plates can be used without limitations. It is preferable that the support to be used is a dimensionally stable plate-like material. Examples of the support include papers, papers laminated with a plastic (for example, polyethylene, polypropylene, and polystyrene), metal plates (for example, aluminum, zinc, and copper), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonates, and polyvinyl acetal), and papers or plastic films having the foregoing metal laminated or vapor deposited thereon. If desired, the surface of such a support may be subjected to a proper known physical or chemical treatment for the purposes of imparting hydrophilicity, enhancing the strength, and so on

In particular, as the preferred support, there are enumerated papers, polyester films, and aluminum plates. Of these, aluminum plates which have good dimensional stability, are relatively cheap and can provide a surface having more excellent hydrophilicity and strength by a surface treatment as the need arises are especially preferable. Furthermore, a composite sheet having an aluminum sheet coupled on a polyethylene terephthalate film as described in JP-B-48-18327 is also preferable.

The aluminum substrate is a dimensionally stable metal plate containing aluminum as the major component and includes pure aluminum plates and alloy plates containing aluminum as the major component and a slight amount of foreign elements. Plastic films or papers having aluminum (alloy) laminated or vapor deposited thereon are also employable.

In the foregoing description, the foregoing substrate made of aluminum or an aluminum alloy is named generically as an aluminum substrate and used. Examples of the foreign elements in the alloy include silicon, iron, manganese, copper, magnesium, chromium, zinc, bismuth, nickel, and titanium. The content of the foreign elements in the alloy is not more than 10 % by weight. In the invention, while a pure aluminum plate is suitable, since it is difficult to produce completely pure aluminum according to the smelting technology, a slight amount of foreign elements may be contained.

With respect to the aluminum plate which is applied in the invention, its composition is not specified, but conventionally known and publicly used raw materials such as JIS A 1050, JIS A 1100, JIS A 3103, and JIS A 3005 can be properly utilized. Furthermore, the thickness of the aluminum substrate which is used in the invention is from about 0.1 mm to 0.6 mm, preferably from 0.15 mm to 0.4 mm, and especially preferably from 0.2 mm to 0.3 mm. This thickness can be properly varied depending upon the size of a printing machine, the size of a printing plate, and the desire of a user. The aluminum substrate may be properly subjected to a substrate surface treatment as described later as the need arises. As a matter of course, the aluminum substrate may not be subjected to a substrate surface treatment.

### [Surface roughing treatment]

The aluminum substrate is usually subjected to a surface roughing treatment. Examples of the surface roughing treatment include mechanical surface roughing, chemical etching, and electrolytic graining as disclosed in JP-A-56-28893. In addition, an electrochemical surface roughing method for performing electrochemical surface roughing in a hydrochloric acid or nitric acid electrolytic liquid and a mechanical surface roughing method such as a wire brush graining method for scratching the aluminum surface by a metallic wire, a ball graining method for graining the aluminum surface by an abrasive ball and an abrasive material, and a brush graining method for subjecting the surface to surface roughing by a nylon brush and an abrasive material are employable. The foregoing surface roughing methods can be carried out singly or in combination. Above all, the method which is usually employed is an electrochemical method for performing chemical surface roughing in a hydrochloric acid or nitric acid electrolytic liquid. The quantity of electricity at the time of anode is suitably in the range of from 50 C/dm² to 400 C/dm². More specifically, it is preferable that alternating current and/or direct current electrolysis is carried out in an electrolytic liquid containing from 0.1 to 50 % of hydrochloric acid or nitric acid under conditions at a temperature of from 20 to 100 °C for a period of time of from 1 second to 30 minutes in a current density of from 100 C/dm² to 400 C/dm².

The thus surface roughed aluminum substrate may be chemically etched with an acid or an alkali. Examples of an etching agent which is suitably used include sodium hydroxide, sodium carbonate, sodium aluminate, sodium metasilicate, sodium phosphate, potassium hydroxide, and lithium hydroxide. Preferred ranges of the concentration and temperature are from 1 to 50 % and from 20 to 100 °C, respectively. After the etching, for the purpose of removing smuts remaining on the surface, acid washing is carried out. Examples of the acid to be used include nitric acid, sulfuric acid, phosphoric acid, chromic acid, hydrofluoric acid, and borofluoric acid. In particular, as the method for removing smuts after the electrochemical surface roughing treatment, a method for bringing it into contact with sulfuric acid of from 15 to 65 % by weight at a temperature of from 50 to 90 °C as described in JP-A-53-12739 and an alkaline etching method as described in JP-B-48-28123 are preferable. So far as after such treatments, the treated surface has a center line average roughness (Ra) of from 0.2 to 0.5 µm, the method and conditions are not particularly limited.

### [Anodic oxidation treatment]

The thus surface roughed aluminum substrate is then subjected to an anodic oxidation treatment to form an oxidized film. For the anodic oxidation treatment, an aqueous solution of sulfuric acid, phosphoric acid, oxalic acid, or boric acid/sodium borate is used singly, or a combination of plural kinds thereof is used as the major component of an electrolytic bath. As a matter of course, the electrolytic liquid may contain components which are usually at least contained in A1 alloy plate, electrodes, tap water, ground water, or the like. In addition, a second or third component may be added. Examples of the second or third component as referred to herein include cations such as ions of metals (for example, Na, K, Mg, Li, Ca, Ti, Al, V, Cr, Mn, Fe, Co, Ni, Cu, and Zn) and an ammonium ion; and anions such as a nitric acid ion, a carbonic acid ion, a chlorine ion, a phosphoric acid ion, a fluorine ion, a phosphorous acid ion, a titanium acid ion, a silicic acid ion, and a boric acid ion. The second or third component may be contained in a concentration of from approximately 0 to 10,000 ppm. Though the conditions of the anodic oxidation treatment are not particularly limited, the anodic oxidation treatment is carried out by direct current or alternating current electrolysis in a concentration ranging from 30 to 500 g/liter at a treatment temperature ranging from 10 to 70 °C in a current density ranging from 0.1 to 40 A/m². The thickness of the formed anodically oxidized film is in the range of from 0.5 to 1.5 µm, and preferably in the range of from 0.5 to 1.0 µm.

In addition, after carrying out these treatments, a treatment for undercoating a water-soluble resin (for example, polyvinyl phosphonic acid, polymers or copolymers having a sulfonic group in the side chain thereof, and polyacrylic acid), a water-soluble metal salt (for example, zinc borate), a yellow dye, an amine salt, etc. is suitable. Moreover, a sol-gel treated substrate which has been subjected to covalent bonding with a functional group capable of causing addition reaction by a radical as disclosed in JP-A-7-159983 is suitably used.

As other preferred examples, there can be enumerated ones in which a waterproof hydrophilic layer is provided as a surface layer on an arbitrary support. Examples of such a surface layer include layers comprising an inorganic pigment and a binder as described in U.S. Patent No. 3,055,295 and JP-A-56-13168, hydrophilic swelling layers as described in JP-A-9-80744, and sol-gel films comprising titanium oxide, polyvinyl alcohol, and a silicic acid as described in JP-T-8-507727. Such a hydrophilic treatment is carried out for the purposes of, in addition to making the surface of the support hydrophilic, preventing harmful reaction of the photopolymerizable composition to be provided thereon and enhancing adhesion of the photosensitive layer.

### [Interlayer]

For the purpose of improving adhesion between the photosensitive layer and the substrate and staining properties, the photosensitive lithographic printing plate in the invention may be provided with an interlayer. Specific examples of the such an interlayer include ones as described in JP-B-50 7481, JP A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824, JP-A-2001-209170, and so on.

### [Coating liquid]

In coating the photosensitive layer, the foregoing respective components are dissolved in a solvent to form a coating liquid. Examples of the solvent which is used herein include organic solvents such as acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate-3-methoxypropyl acetate, N,N-dimethylformamide, dimethyl sulfoxide, γ-butyrolactone, methyl lactate, and ethyl lactate. Such a solvent can be used singly or in admixture.

The concentration of solids in the coating liquid is usually from 1 to 50 % by weight.

Furthermore, for the purpose of enhancing the coating surface quality, it is possible to add a surfactant.

The coating amount of the photosensitive layer is usually from about 0.1 to about 10 g/m², preferably from 0.3 to 5 g/m², and more preferably from 0.5 to 3 g/m² in terms ofweight after drying.

### [Protective layer]

The protective layer which is used in the invention is characterized in that the oxygen permeability A at 25 °C under one atmosphere is 1.0 ≤ A ≤ 20 (cc/m²· day). When the oxygen permeability A is less than 1.0 (cc/m²·day) and is extremely low, there are caused problems such as the generation of unnecessary polymerization reaction at the time of production and unprocessed stock storage, the generation of unnecessary fog or the occurrence of thickening of image lines at the time of image exposure. Conversely, when the oxygen permeability A exceeds 20 (cc/m²·day) and is excessively high, a lowering of the sensitivity is caused.

Furthermore, in addition to the foregoing oxygen permeability, the protective layer is further desired to have such characteristics that it does not substantially hinder the transmission of light to be used for exposure; that it has excellent adhesion to the photosensitive layer; and that it can be easily removed in a development step after exposure. Devices regarding such a protective layer have hitherto been made, and details thereof are described in U.S. Patent No. 3,458,311 and JP-A-55-49729.

As materials which can be used in the protective layer, for example, it is preferred to use a water-soluble high molecular compound having relatively excellent crystallinity Specifically, there are enumerated water-soluble polymers such as polyvinyl alcohol, polyvinyl alcohol/vinyl phthalate copolymers, vinyl acetate/vinyl alcohollvinyl phthalate copolymers, vinyl acetate/crotonic acid copolymers, polyvinylpyrrolidone, acidic celluloses, gelatin, gum arabic, polyacrylic acid, and polyacrylamide. Such a compound can be used singly or in admixture. Above all, what polyvinyl alcohol is used as the major component brings the most satisfactory results in view of basic characteristics such as oxygen-blocking properties and development eliminating properties.

With respect to the polyvinyl alcohol which is used in the protective layer, so far as an unsubstituted vinyl alcohol unit for having necessary oxygen-blocking properties and water solubility is contained, a part thereof may be substituted with an ester, an ether or an acetal. Similarly, a part of the polyvinyl alcohol may have other copolymerization component. As specific examples, there can be enumerated polyvinyl alcohols which are hydrolyzed to an extent of from 71 to 100 % by mole and which have a molecular weight in the range of from 300 to 2,400. Specific examples thereof include PVA-105, PVA-110, PVA-117, PVA-117H, PVA-120, PVA-124, PVA-124K PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, all of which are manufactured by Kuraray Co., Ltd. In a preferred embodiment, the content of the polyvinyl alcohol in the protective layer is preferably from 20 to 95 % by weight, and more preferably from 30 to 90 % by weight.

As the component which is mixed with polyvinyl alcohol and used, polyvinylpyrrolidone or a modified product thereof is preferable from the viewpoints of oxygen-blocking properties and development eliminating properties, and its content in the protective layer is from 3.5 to 80 % by weight, preferably from 10 to 60 % by weight, and more preferably from 15 to 30 % by weight.

The components of the protective layer (selection of PVA and use of additives), coating amount, and the like are chosen while taking into consideration fog properties, adhesion, and scratch properties in addition to the oxygen-blocking properties and development eliminating properties. In general, the higher the degree of hydrolysis of PVA to be used (the higher the content of an unsubstituted vinyl alcohol unit in the protective layer) or the thicker the film thickness, the higher the oxygen-blocking properties, and hence, such is advantageous in view of the sensitivity. However, when the oxygen-blocking properties are made extremely high, there are caused problems such as the generation of unnecessary polymerization reaction at the time of production and unprocessed stock storage and the generation of unnecessary fog or the occurrence of thickening of image lines at the time of image exposure. Furthermore, when the content of the polyvinylpyrrolidone to be mixed and used is high, it is possible to lower the oxygen-blocking properties. The protective layer in the invention is required such that the oxygen permeability A at 25 °C under one atmosphere is 1.0≤A≤20(cc/m²·day). The oxygen permeability A is preferably in the range of 1.5 ≤ A ≤ 12 (cc/m²·day), and more preferably 2.0 ≤ A ≤ 8.0 (cc/m²·day). The molecular weight of the foregoing (co)polymer such as polyvinyl alcohol (PVA) to be used is usually in the range of from 2,000 to 10,000,000, and preferably in the range of from 20,000 to 3,000,000.

As other composition of the protective layer, glycerin, dipropylene glycol, or the like is added in an amount corresponding to several weight % against the (co)polymer, whereby flexibility can be imparted. Also, an anionic surfactant (for example, sodium alkylsulfates and sodium alkylsulfonates); an ampholytic surfactant (for example, alkylaminocarboxylates and alkylaminodicarboxylates); or a nonionic surfactant (for example, polyoxyethylene alkylphenyl ethers) can be added in an amount of several weight % against the (co)polymer. The film thickness of the protective layer is suitably from 0.5 to 5 µm, and especially suitably from 1 to 3 µm.

Furthermore, adhesion to the image area and scratch resistance are extremely important in handling the plate. Namely, when a hydrophilic layer made of a water-soluble polymer is laminated on an oleophilic polymer layer, film separation is liable to occur due to an insufficient adhesive strength, and the separated area causes a defect such as film curing failure due to polymerization hindrance of oxygen. In this issue, in order to improve the adhesion between these two layers, there have been made a variety of proposals. For example, U.S. Patent Application Serial Nos. 292,501 and 44,563 describe that by mixing from 20 to 60 % by weight of an acrylic emulsion or a water-insoluble vinylpyrrolidone-vinyl acetate copolymer, etc. in a hydrophilic polymer composed mainly of polyvinyl alcohol and laminating it on the polymer layer, sufficient adhesion is obtained. All of these known technologies can be applied to the protective layer in the invention. Such a coating method of the protective layer is described in detail in, for example, U.S. Patent No. 3,458,311 and JP-A-55-49729.

The coating amount of the protective layer is in general from 0.1 to 10 g/m², and preferably from 0.5 to 5 g/m² on a dry basis.

Next, a plate-making process of the photosensitive lithographic printing plate of the invention will be hereunder described in detail. After image exposure, the foregoing photosensitive lithographic printing plate is developed with an alkaline aqueous solution. The developing solution which is used in the plate-making process of the invention will be described below.

### [Developing solution]

Though the developing solution to be used in the plate-making process of the photosensitive lithographic printing plate of the invention is not particularly limited, for example, a developing solution containing an inorganic alkaline salt and a nonionic surfactant and usually having a pH of from 11.0 to 12.5 is suitably used.

The inorganic alkaline salt can be properly used. Examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These inorganic alkaline agents may be used singly or in combination of two or more kinds thereof

In the case where a silicate is used, it is possible to easily adjust developability by regulating a mixing ratio and a concentration of silicon oxide SiO₂ as a component of the silicate and an alkaline oxide M₂O (wherein M represents an alkali metal or an ammonium group). Among the foregoing alkaline aqueous solutions, ones having a mixing ratio of the foregoing silicon oxide SiO₂ and the alkaline oxide M₂O (a molar ratio of SiO₂/M₂O) of from 0.5 to 3.0 are preferable, and ones having the subject mixing ratio of from 1.0 to 2.0 are more preferable. The amount of addition of the foregoing SiO₂/M₂O mixture is preferably from 1 to 10 % by weight, more preferably from 3 to 8 % by weight, and most preferably from 4 to 7 % by weight based on the weight of the alkaline aqueous solution. When this concentration falls within the foregoing range, the developability and treatment ability are not lowered, the generation of precipitation or the formation of a crystal does not occur, and gelation does not occur during neutralization at the time of discharging a waste liquid so that the treatment of waste liquid is not impaired.

Furthermore, for the purposes of finely regulating the alkaline concentration and assisting the solubility of the photosensitive layer, an organic alkaline agent may be auxiliarily used jointly. Examples of the organic alkaline agent which can be used jointly include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combination of two or more kinds thereof.

The surfactant can be properly used. Examples thereof include nonionic surfactants such as polyoxyalkylene ether group-containing nonionic surfactants, polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate); anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalenesulfonate, and sodium octylnaphthalenesulfonate), alkylsulfuric acid salts (for example, sodium laurylsulfate), alkylsulfonic acid salts (for example, sodium dodecylsulfonate), and sulfosuccinic acid ester salts (for example, sodium dilaurylsulfosuccinate); and ampholytic surfactants such as alkyl betaines (for example, lauryl betaine and stearyl betaine) and amino acids. Of these, polyoxyalkylene ether group-containing nonionic surfactants are especially preferable.

As the polyoxyalkylene ether group-containing nonionic surfactant, ones having a structure represented by the following formula (I) are suitably used.

R⁴⁰-O-(R⁴¹-O)ₚH (I)

In the foregoing formula (I), R⁴⁰ represents an alkyl group having from 3 to 15 carbon atoms, an aromatic hydrocarbon group having from 6 to 15 carbon atoms, or a heteroaromatic ring group having from 4 to 15 carbon atoms (incidentally, examples of the substituent include an alkyl group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); R⁴¹ represents an alkylene group having from 1 to 100 carbon atoms; and p represents an integer of from 1 to 100. Incidentally, these respective groups may contain a substituent, and examples of the substituent include an alkyl group having from 1 to 20 carbon atoms and an aromatic hydrocarbon group having from 6 to 15 carbon atoms.

In the definition of the foregoing formula (I), specific examples of the "aromatic hydrocarbon group" include a phenyl group, a tolyl group, a naphthyl group, an anthryl group, a biphenyl group, and a phenanthryl group; and specific examples of the "heteroaromatic ring group" include a furyl group, a thienyl group, an oxazolyl group, an imidazolyl group, a pyranyl group, a pyridinyl group, an acridinyl group, a benzofuranyl group, a benzothienyl group, a benzopyranyl group, a benzoxazolyl group, and a benzimidazolyl group.

Furthermore, the (R⁴¹-O)ₚ moiety of the formula (I) may be a combination of two or three kinds of groups so far as it falls within the foregoing range. Specifically, there are enumerated random or block-like forms of a combination, for example, a combination of an ethyleneoxy group and a propyleneoxy group, a combination of an ethyleneoxy group and an isopropyloxy group, a combination of an ethyleneoxy group and a butyleneoxy group, and a combination of an ethyleneoxy group and an isobutylene group. In the invention, the polyoxyalkylene ether group-containing surfactant is used singly or in a composite system. It is effective to add the polyoxyalkylene ether group-containing surfactant in an amount of from 1 to 30 % by weight, and preferably from 2 to 20 % by weight in the developing solution. When the addition amount is too low, the developability may be possibly lowered, while it is too high, damage of the development is so strong that printing resistance of a printing plate may be possibly lowered.

Furthermore, examples of the polyoxyalkylene ether group-containing nonionic surfactant represented by the foregoing formula (I) include polyoxyethylene alkyl ethers (for example, polyoxyethylene lauryl ether, polyoxyethylene cetyl ether, and polyoxyethylene stearyl ether), polyoxyethylene aryl ethers (for example, polyoxyethylene phenyl ether and polyoxyethylene naphthyl ether), and polyoxyethylene alkylaryl ethers (for example, polyoxyethylene methylphenyl ether, polyoxyethylene octylphenyl ether, and polyoxyethylene nonylphenyl ether).

Such a surfactant can be used singly or in combination. Furthermore, the content of such a surfactant in the developing solution is suitably in the range of from 0.1 to 20 % by weight as reduced into an active ingredient.

The pH of the developing solution which is used in the plate-making process of the invention is usually from 11.0 to 12.7, and preferably from 11.5 to 12.5 in view of the image formation and development damage in the exposed area.

Furthermore, it is preferable that the developing solution which is used in the invention has a conductivity of from 3 to 30 mS/cm. When the conductivity is lower than the foregoing range, in general, elution of the photopolymerizable composition on the surface of the aluminum plate support becomes difficult, thereby causing staining during printing. On the other hand, when the conductivity exceeds the foregoing range, since the salt concentration is high, an elution rate of the photosensitive layer becomes extremely low so that a residual film may be possibly generated in an unexposed area. The conductivity is especially preferably in the range of from 5 to 20 mS/cm

### (Exposure and development treatment)

By image exposing the photosensitive lithographic printing plate in the invention by conventionally known active rays such as a carbon arc lamp, a high pressure mercury vapor lamp, a xenon lamp, a metal halide lamp, a fluorescent lamp, a tungsten lamp, a halogen lamp, a helium-cadmium laser, an argon ion laser, an FD·YAG laser, a helium-neon laser, and a semiconductor laser (from 350 nm to 600 nm) and then developing it, it is possible to form an image on the surface of the aluminum plate support.

For the purpose of enhancing a rate of curing of the photosensitive layer, a heating process to be carried out at a temperature of from 50 °C to 140 °C for a period of time of from 1 second to 5 minutes may be provided and carried out after the image exposure but before the development. When the heating temperature falls within the foregoing range, an effect for increasing the rate of curing is brought, and a residual film due to dark polymerization in an unexposed area is not generated.

Furthermore, as described previously, the protective layer is provided on the photosensitive layer of the photosensitive lithographic printing plate in the invention. There is known a method for achieving the removal of the protective layer and the removal of the unexposed area of the photosensitive layer at the same time by using a developing solution, or a method for removing the protective layer with water or warm water and then removing the photosensitive layer in the unexposed area with a developing solution. An antiseptic, etc. as described in JP-A-10-10754 or an organic solvent, etc. as described in JP-A 8-278636 can be contained in such water or warm water.

The development of the photosensitive lithographic printing plate in the invention with the foregoing developing solution is carried out according to a usual method at a temperature of from about 0 to 60 °C, and preferably from about 15 to 40 °C by, for example, dipping the exposed photosensitive lithographic printing plate in the developing solution and rubbing it by a brush or other means.

In addition, in the case where the development treatment is carried out by using an automatic processor, since the developing solution fatigues corresponding to the amount of treatment, treatment ability may be recovered by using a replenisher or a fresh developing solution. The thus developed photosensitive lithographic printing plate is subjected to post treatments with washing water, a rinse liquid containing a surfactant, etc., and a desensitizing liquid containing gum arabic, a starch derivative, etc. as described in JP-A-54-8002, JP-A-55-115045, JP-A-59-58431, and the like. In the invention, for the post treatments of the photosensitive lithographic printing plate, a combination of a variety of these treatments can be employed.

In the printing plate as obtained by the foregoing treatments, its printing resistance can be enhanced by a post exposure treatment or a heating treatment such as burning as described in JP-A-2000-89478.

The lithographic printing plate as obtained by these treatments is set in an offset printing machine and provided for printing of a number of sheets.

### EXAMPLES

The invention will be hereunder described in detail with reference to the following Examples, but as a matter of course, it should not be construed that the invention is limited thereto.

### [Examples 1 to 3 and Comparative Examples 1 to 2]

### (Preparation method of aluminum support)

An aluminum plate having a thickness of 0.3 mm was etched by dipping in 10 % by weight sodium hydroxide at 60 °C for 25 seconds, washed with running water, neutralized and washed with 20 % by weight nitric acid, and then washed with water.

This aluminum plate was subjected to an electrolytic surface roughing treatment in a quantity of electricity at the time of anode of 300 coulombs/dm² in a 1 % by weight nitric acid aqueous solution using an alternating waveform current of sine wave. Subsequently, the resulting aluminum plate was dipped in a 1 % by weight sodium hydroxide aqueous solution at 40 °C for 5 seconds; dipped in a 30 % by weight sulfuric acid aqueous solution; subjected to a desmutting treatment at 60 °C for 40 seconds; and then subjected to an anodic oxidation treatment in a 20 % by weight sulfuric acid aqueous solution for 2 minutes in a current density of 2 A/dm² such that the anodically oxidized film had a thickness of 2.7 g/m². A surface roughness thereof was measured and found to be 0.3 µm (in terms of an Ra expression according to JIS B0601).

### [Interlayer]

On the thus treated aluminum plate, the following interlayer liquid was first coated using a bar coater and then dried at 80 °C for 20 seconds. A coating weight of the interlayer after drying was 10 mg/m².

### Interlayer liquid

- Sol liquid as described below: 100 g
- Methanol: 900 g

### Sol liquid

- PHOSMER PE (manufactured by Uni-Chemical Co., Ltd.): 5 g
- Methanol: 45 g
- Water: 10 g
- 85 % phosphoric acid: 5 g
- Tetraethoxysilane: 20 g
- 3-Methacryloxypropyltrimethoxysilane: 15 g

### <Formation of photosensitive layer>

A highly sensitive photopolymerizable composition P-1 having the following composition was coated on this interlayer in a dry coating weight of 1.4 g/m² and dried at 100 °C for one minute to form a photosensitive layer.

| (Photopolymerizable composition P-1) | |
|---|---|
| Ethylenically unsaturated bond-containing compound (A1): | 4.2 parts by weight |
| Linear organic high molecular polymer (high molecular binder) (B1): | 3.6 parts by weight |
| Sensitizer (C1): | 0.21 parts by weight |
| Photopolymerization initiator (D1): | 0.81 parts by weight |
| Chain transfer agent (E1): | 0.3 parts by weight |
| ε-Phthalocyanine dispersion: | 0.76 parts by weight |
| Fluorine based nonionic surfactant, MEGAFAC F780 (manufactured by Dainippon Ink and Chemicals, Incorporated) | 0.05 parts by weight |
| Methyl ethyl ketone: | 58 parts by weight |
| Propylene glycol monomethyl ether acetate: | 53 parts by weight |

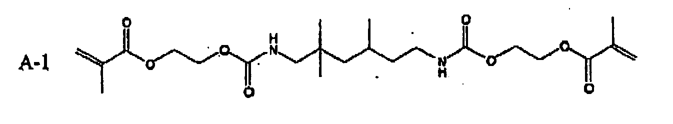

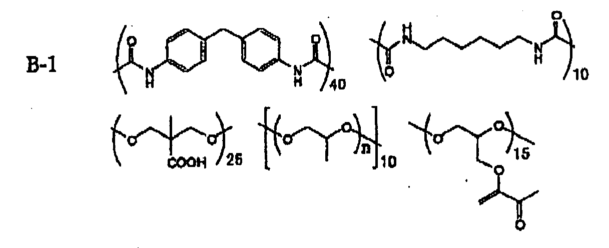

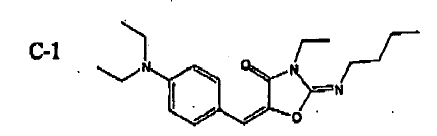

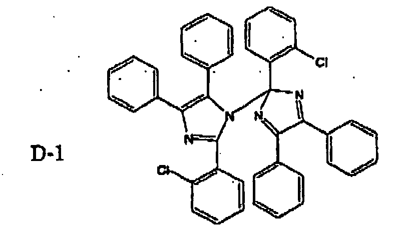

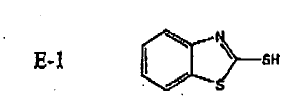

### <Formation of protective layer>

A composition as described in Table 1 was coated on this photosensitive layer in a dry coating weight of 2.45 g/m² and dried at 120 °C for one minute to form a photosensitive lithographic printing plate.

**Table 1: Composition of protective layer**

| | Protective layer 1 | Protective layer 2 | Protective layer 3 | Comparative protective layer 1 | Comparative protective layer 2 |
|---|---|---|---|---|---|
| PVA 105 | 75.7 | | 47.4 | 98 | |
| PVA 205 | | 89.35 | | | |
| PVA, 405 | | | 45 | | 98 |
| PIONIN D625 | | 3 | | | |
| LUVISKOL VA64W (manufactured by BASF AG) | 2.5 | 2.4 | 2.4 | | |
| Polyvinylpyrrolidone (manufactured by Wako Pure Chemical Industries, Ltd.) | 20 | 3.5 | 3.5 | | |
| EMALEX 710 (manufactured by Nihon Emulsion Co., Ltd.) | 1.8 | 1.75 | 1.7 | 2 | 2 |

### [Evaluation]

### (1) Printing resistance:

The resulting photosensitive lithographic printing plate was imagewise drawn by Vx9600CTP (light source wavelength: 405 nm) as manufactured by Fuji Photo Film Co., Ltd. while regulating the exposure amount on the photographic material at 0.05 mJ/cm². Thereafter, the photosensitive lithographic printing plate was developed for a development time of 28 seconds by using a PS processor IP850HD as manufactured G&J in which an alkaline developing solution having the following composition had been charged while keeping a liquid temperature at 25 °C. The lithographic printing plate was printed with an ink of DIC-GEOS(N) SUMI as manufactured by Dainippon Ink and Chemical, Incorporated by using a LTTHRONE printing machine as manufactured by Komori Corporation. The printing resistance was printed in terms of the number of printed sheets at the point when the density of a solid image was visually observed to begin to fade.

Here, a rate of oxygen permeation of the oxygen-blocking layer at a coating amount (g/m²) as described in Table 2 was measured under the following condition. The results were shown as oxygen permeability in Table 2.

### (Measurement of rate of oxygen permeation)

On the surface of printing paper having a thickness of about 200 µm, the both surfaces of which had been coated with polyethylene having a thickness of about 20 µm, an oxygen-blocking layer the same as that coated on the foregoing photopolymerizable layer was coated and dried to prepare a sample for measurement. A rate of oxygen permeation of the printing paper as measured in advance was about 700 mL/(m²·day·atom) under the following measurement condition, a value of which could be sufficiently neglected in measuring the rate of oxygen permeation in the oxygen-blocking layer.

By using the thus obtained sample, a rate of oxygen permeation [mL/(m²-day·atom)] was measured under a condition at 25 °C and 60 % RH using Mocon's OX-TRAN2/20 according to the gas permeability test method as described in JIS K7126B and ASTM D3985.

| (Composition of alkaline developing solution) | |
|---|---|
| Potassium hydroxide: | 0.15 g |
| Polyoxyethylene naphthyl ether (n = 13): | 5.0 g |
| CHELEST 400 (chelating agent): | 0.1 g |
| Water: | 94.75 g |

### (2) Stability with the lapse of time:

A halftone dot area was measured in the exactly same manner as in that at the time of evaluation of sensitivity, except for scaling the foregoing photosensitive lithographic printing plate with aluminum kraft paper along with a slip sheet and allowing it to stand at 60 °C for 3 days. Next, a difference between the halftone dot area with allowing to stand at 60 °C for 3 days and the halftone dot area without allowing to stand at 60 °C for 3 days was taken, thereby measuring a halftone dot fluctuation (Δ %) with the forced lapse of time. It is meant that when the absolute value of this numeral is small, the influence due to the forced lapse of time is small, namely the storage stability is high.

**Table 2**

| | Example 1 | Example 2 | Example 3 | Comparative Example 1 | Comparative Example 2 |
|---|---|---|---|---|---|
| Protective layer | Protective layer 1 | Protective layer 2 | Protective layer 3 | Comparative protective layer 1 | Comparative protective layer 2 |
| Oxygen permeability (cc/m²·day) | 2.2 | 5.4 | 5.7 | 0.1 | 150 |
| Printing resistance (× 10,000 sheets) | 21 | 20 | 20 | 21 | 1 |
| Forced lapse of time (%) | 0 | 1 | 1 | Fogged | -5 |

### [Examples 4 to 5 and Comparative Examples 3 to 5]

### (Example 4)

A lithographic printing plate of Example 4 was obtained in the same manner as in Example 1, except for changing the linear organic high molecular polymer (high molecular binder) (B1) of Example 1 to B2.

### (Example 5)

A lithographic printing plate of Example 5 was obtained in the same manner as in Example 1, except for changing the linear organic high molecular polymer (high molecular binder) (B1) of Example 1 to B3.

### (Comparative Example 3)

A lithographic printing plate of Comparative Example 3 was obtained in the same manner as in Comparative Example 1, except for changing the linear organic high molecular polymer (high molecular binder) (B1) of Comparative Example 1 to B2.

### (Comparative Example 4)

A lithographic printing plate of Comparative Example 4 was obtained in the same manner as in Comparative Example 1, except for changing the linear organic high molecular polymer (high molecular binder) (B 1) of Comparative Example 1 to B3.

### (Comparative Example 5)

A lithographic printing plate of Comparative Example 5 was obtained in the same manner as in Comparative Example 1, except for changing the linear organic high molecular polymer (high molecular binder) (B1) of Example 1 to B4.

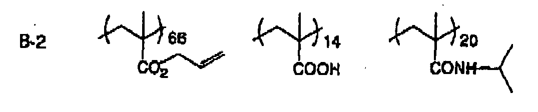

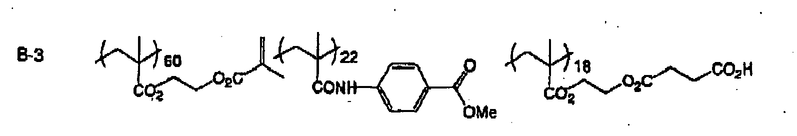

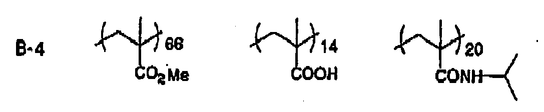

**Table 3**

| | Example 4 | Example 5 | Comparative Example 3 | Comparative Example 4 | Comparative Example 5 |
|---|---|---|---|---|---|
| Protective layer | Protective layer 1 | Protective layer 2 | Comparative protective layer 1 | Comparative protective layer 2 | Protective layer 1 |
| Oxygen permeability (cc/m²·day) | 2.2 | 2.2 | 0.1 | 0.1 | 2.2 |
| Printing resistance (x 10,000 sheets) | 10 | 14 | 11 | 14 | 6 |
| Forced lapse of time (%) | 0 | 1 | Fogged | Fogged | -4 |

As is clear from Table 2 and Table 3, in the photosensitive lithographic printing plates of the respective Examples in which the oxygen permeability A of the protective layer falls within the range of 1.0 ≤ A ≤ 20 (cc/m²·day), an aspect of which is a characteristic feature of the invention, both the printing resistance and the storage stability were compatible with each other, and satisfactory results were obtained. On the other hand, in the photosensitive lithographic printing plates of the respective Comparative Examples, the results were unsatisfactory in some kind of natures.

This application is based on Japanese Patent application JP 2004-278360, filed September 24, 2004, the entire content of which is hereby incorporated by reference, the same as if set forth at length.

## Claims

1. A photosensitive lithographic printing plate comprising:
a hydrophilic support;
a photosensitive layer; and
a protective layer,
wherein the photosensitive layer contains a compound having an ethylenically unsaturated double bond, a high molecular binder having a crosslinking group and a hexaaryl biimidazole compound; and the protective layer has an oxygen permeability at 25 °C under one atmosphere of from 1.0 to 20 cc/m²·day.

2. The photosensitive lithographic printing plate according to claim 1, wherein the high molecular binder is a polyurethane resin having a crosslinking group.

3. The photosensitive lithographic printing plate according to claim 1, wherein the high molecular binder is (meth)acrylic resin having a crosslinking group.

4. The photosensitive lithographic printing plate according to claim 1, wherein the crosslinking group is an ethylenically unsaturated bond goup.

5. The photosensitive lithographic printing plate according to claim 1, wherein the photosensitive layer further contains a cosensitizer.

6. The photosensitive lithographic printing plate according to claim 1, wherein the photosensitive layer further contains a thermal polymerization inhibitor.

7. The photosensitive lithographic printing plate according to claim 1, wherein the protective layer contains a polyvinyl alcohol.

8. The photosensitive lithographic printing plate according to claim 7, wherein the protective layer further contains polyvinylpyrrolidone or a modified product thereof.

9. The photosensitive lithographic printing plate according to claim 7, wherein a coating amount of the protective layer after drying is from 0.1 to 10 g/m².

10. The photosensitive lithographic printing plate according to claim 7, wherein a coating amount of the protective layer after drying is from 0.5 to 5 g/m².
